(19) Europäisches Patentamt / European Patent Office / Office européen des brevets

(11) **EP 3 010 149 B1**

(12) **FASCICULE DE BREVET EUROPEEN**

(45) Date de publication et mention
de la délivrance du brevet:
**14.08.2019 Bulletin 2019/33**

(21) Numéro de dépôt: **15187022.7**

(22) Date de dépôt: **28.09.2015**

(51) Int Cl.:
*H03H 9/54* *(2006.01)*       *H03H 3/007* *(2006.01)*
*H03H 9/02* *(2006.01)*       *H03H 9/56* *(2006.01)*
*H03H 9/70* *(2006.01)*       *H03H 9/72* *(2006.01)*
*H03H 3/02* *(2006.01)*       *H03H 3/04* *(2006.01)*
*H03H 7/38* *(2006.01)*       *H03H 9/64* *(2006.01)*

(54) **CIRCUIT RESONANT A FREQUENCE ET A IMPEDANCE VARIABLES**

RESONANZSCHALTUNG MIT VARIABLER FREQUENZ UND IMPEDANZ

RESONANT CIRCUIT WITH VARIABLE FREQUENCY AND IMPEDANCE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.09.2014 FR 1459210**

(43) Date de publication de la demande:
**20.04.2016 Bulletin 2016/16**

(73) Titulaire: **COMMISSARIAT À L'ÉNERGIE
ATOMIQUE ET AUX
ÉNERGIES ALTERNATIVES
75015 Paris (FR)**

(72) Inventeurs:
• **DAVID, Jean-Baptiste
38000 Grenoble (FR)**

• **REINHARDT, Alexandre
38400 Saint Martin d'Heres (FR)**

(74) Mandataire: **Esselin, Sophie et al
Marks & Clerk France
Conseils en Propriété Industrielle
Immeuble Visium
22 avenue Aristide Briand
94117 Arcueil Cedex (FR)**

(56) Documents cités:
**WO-A1-03/055063       WO-A1-2013/125360
US-A1- 2005 146 401    US-A1- 2005 212 612
US-A1- 2007 296 513    US-A1- 2009 115 553
US-A1- 2011 012 696    US-A1- 2012 313 731
US-A1- 2013 169 383    US-B1- 6 291 924**

**Description**

Le domaine de l'invention est celui des circuits résonants et plus particulièrement celui des circuits pouvant être utilisés dans des filtres radiofréquences dont on cherche à faire varier la fréquence centrale et la largeur de bande, dans le cadre par exemple d'applications de télécommunications sans fil.

Les architectures actuelles de systèmes de télécommunication sont conçues de telle manière qu'elles peuvent s'adapter à plusieurs standards de communication. On dit qu'elles sont multistandards. C'est là une propriété essentielle qui permet à un système de fonctionner dans plusieurs régions géographiques et avec l'aide de plusieurs réseaux. Pour réaliser cette fonction, les systèmes actuels reposent en réalité sur une batterie de sous-systèmes mis en parallèle, et commutés en fonction du scenario d'utilisation.

En particulier, l'émetteur/récepteur d'un système multistandard exploite autant de filtres radiofréquences ou duplexeurs que le nombre de standards pris en charge l'exige. Les filtres et les duplexeurs ont la propriété de sélectionner une fraction du spectre fréquentiel - la fraction dite « utile » au système, parce qu'elle contient l'information à traiter.

Aujourd'hui, ces filtres sont majoritairement réalisés à l'aide de la technologie piézoélectrique, et ils se déclinent en deux grandes familles : les filtres utilisant des résonateurs à ondes de surface « Surface Acoustic Wave » ou « SAW » et les filtres utilisant des résonateurs à ondes de volume « Bulk Acoustic Wave » ou « BAW ». Ce type de filtres s'est imposé dans les systèmes de télécommunications parce qu'ils sont aujourd'hui relativement simples à réaliser de manière intégrée, et occupent donc un espace minimum (quelques millimètres carrés) pour un coût économiquement satisfaisant.

Cependant, ces composants fonctionnent avec l'aide d'un matériau et d'une architecture qui imposent une fréquence centrale et une largeur de bande pour chacun.

Or, avec la multiplication des standards de télécommunications, et les spécificités géographiques, le nombre de ces composants de filtrage dans les systèmes embarqués a tendance à augmenter. Il devient désormais très utile de trouver un moyen de rendre les filtres variables en fréquence centrale et en largeur de bande, de manière à réduire leur nombre, voire à n'en avoir plus qu'un seul.

De manière générale construits autour d'un matériau aux propriétés piézoélectriques, les filtres SAW/BAW exploitent la conversion électromécanique de l'énergie contenue dans des résonateurs acoustiques, pour réaliser une fonction de filtrage.

Alors que le résonateur SAW exploite des vibrations acoustiques confinées à la surface d'un substrat piézoélectrique, le résonateur BAW est obtenu par vibration dans son épaisseur, d'une mince couche de matériau piézoélectrique prise en sandwich entre deux électrodes.

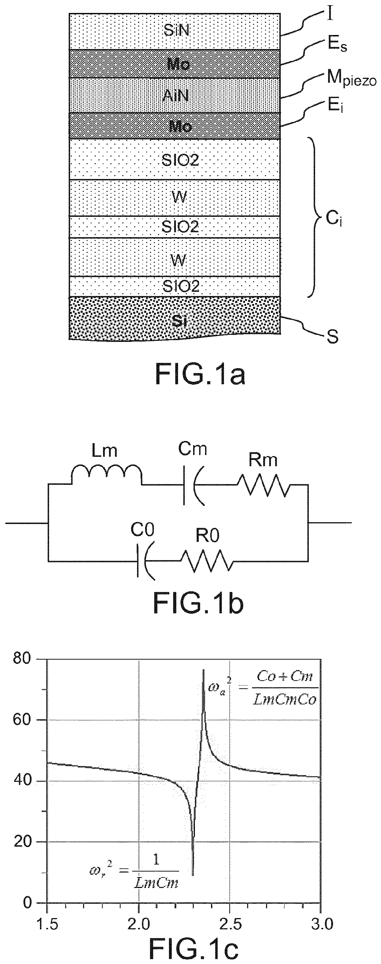

Les figures 1a, 1b et 1c illustrent le comportement d'un résonateur BAW.

Plus précisément, la figure 1a montre un empilement classique de matériaux pour la réalisation d'un résonateur BAW de type « Solidly Mounted Resonator », comprenant à la surface d'un substrat S, un empilement de couches Ci, assurant une fonction de réflecteur, et une couche de matériau piézoélectrique Mpiézo comprise entre deux électrodes Ei et Es, recouverte d'une couche de diélectrique I. La figure 1b montre le schéma électrique équivalent au premier ordre d'un résonateur piézoélectrique et la figure 1c illustre les fréquences de résonance et d'antirésonance du résonateur piézoélectrique.

Dans les deux cas SAW/BAW, ce phénomène acoustique s'interprète sur le plan électrique comme l'agencement d'un résonateur « RLC » en parallèle avec une capacité. Ce modèle, très répandu dans la littérature, est communément désigné par l'abréviation « BVD », pour « Butterworth-Van Dyke ». Il présente alors une résonance série (quasi-court-circuit) et une antirésonance (quasi-circuit-ouvert). La distance fréquentielle qui sépare la résonance de l'antirésonance est caractérisée par le coefficient de couplage électromécanique du résonateur défini par l'équation suivante :

$$k_{eff}^2 = \frac{\pi}{2}\frac{f_s}{f_p}\tan\left(\frac{\pi}{2}\frac{f_p - f_s}{f_p}\right)$$

avec fs : la fréquence de résonance et fp : la fréquence d'antirésonance.

Ce paramètre est directement lié aux propriétés piézoélectriques du matériau et au mode de vibration considéré.

Typiquement, pour des ondes de volume se propageant dans de l'AIN (Nitrure d'Aluminium), le coefficient de couplage électromécanique est de l'ordre de 7%, et permet de concevoir des filtres dont la largeur de bande est de l'ordre de 2%.

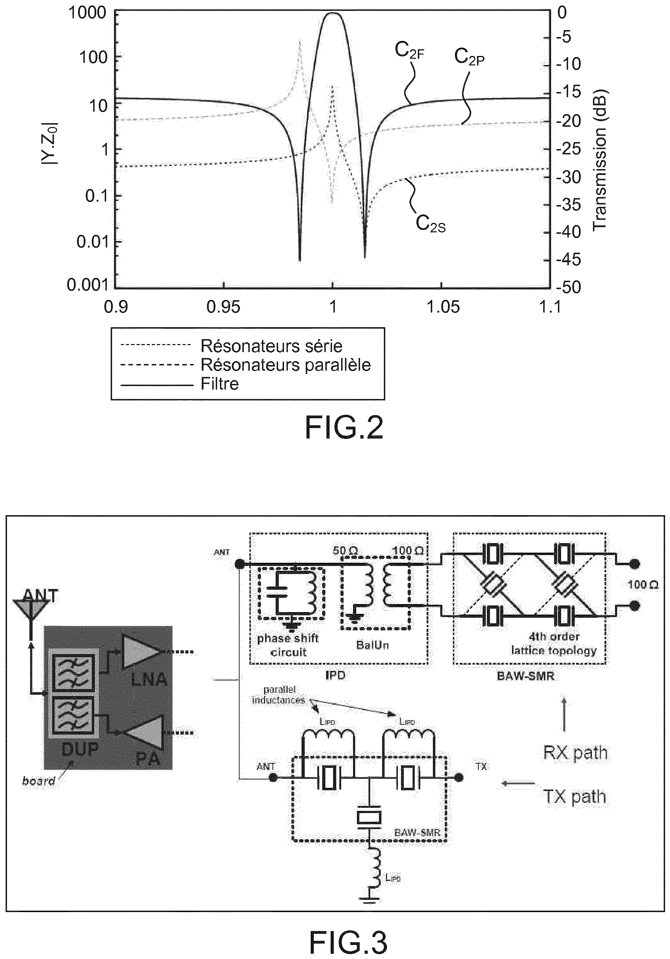

Un filtre est obtenu par l'agencement de plusieurs résonateurs, parfois accompagnés d'éléments passifs supplémentaires. Typiquement, on distingue deux genres de résonateurs pour concevoir un filtre : les résonateurs mis en parallèle au chemin du signal, et les résonateurs mis en série sur le chemin du signal. Ils se distinguent électriquement par le positionnement fréquentiel de leurs fréquences de résonance et d'antirésonance, disposées généralement selon le schéma illustré en figure 2 qui donne la réponse du filtre (courbe C$_{2F}$).

En particulier, la fréquence de résonance des résonateurs mis en série (courbe C$_{2s}$), est alignée sur la fréquence d'antirésonance des résonateurs mis en parallèle (courbe C$_{2p}$).

Les résonateurs acoustiques, en dehors de leurs fréquences remarquables, présentent un comportement capacitif, et présentent donc une impédance qui dépend en premier lieu de leur capacité statique équivalente. On nomme plus tard « impédance caractéristique Zc » cette impédance liée au comportement capacitif d'un résonateur en dehors de ses fréquences remarquables. Le dimensionnement de ce condensateur intervient dans l'adaptation d'impédance du filtre. On montre que lorsque les résonateurs séries et parallèles sont disposés selon le principe décrit ci-avant, l'adaptation du filtre est obtenue si l'impédance Z$_{eq}$ du générateur et de la charge équivaut à la moyenne géométrique des impédances caractéristiques des résonateurs :

$$Z_{eq} = \sqrt{Z_{serie} \cdot Z_{serie}}$$

Pour exemple, la figure 3 présente la topologie d'un duplexeur (association de deux filtres pour l'échange d'information en duplex fréquentiel). On y repère deux groupes de résonateurs, ainsi que quelques éléments passifs.

Tandis que l'agencement des résonateurs sur le chemin « RX » est différentiel et croisé (dit « Treillis », ou *lattice* en anglais), les résonateurs sur le chemin TX sont disposés en « échelle » (*Ladder en* anglais).

A ce jour, quelques industriels dominent le marché des filtres/duplexeurs à base de BAW ou de SAW. Tous sans exception proposent des batteries de composants, chaque composant adressant une bande fréquentielle spécifique, ou un standard spécifique (dans le cas des duplexeurs). Ceci est imposé par les propriétés intrinsèques du matériau piézoélectrique, ainsi que par l'approche architecturale des filtres, comme explicité ci-après dans la présente description.

Dès 2005 a été publiée une proposition visant à modifier les fréquences remarquables des résonateurs acoustiques, ouvrant ainsi la voie aux filtres variables comme décrit dans l'article de Carpentier, J.F. ; Tilhac, C. ; Caruyer, G. ; Dumont, F., « A tunable bandpass BAW-filter architecture and its application to WCDMA filter », 2005 IEEE MTT-S International Microwave Symposium Digest. Le principe repose sur l'adjonction de capacités et d'inductances et série et en parallèle à chaque résonateur. Les auteurs avancent qu'une variation de 2% de la fréquence de travail est possible, mais ceci n'a jamais été démontré par la réalisation.

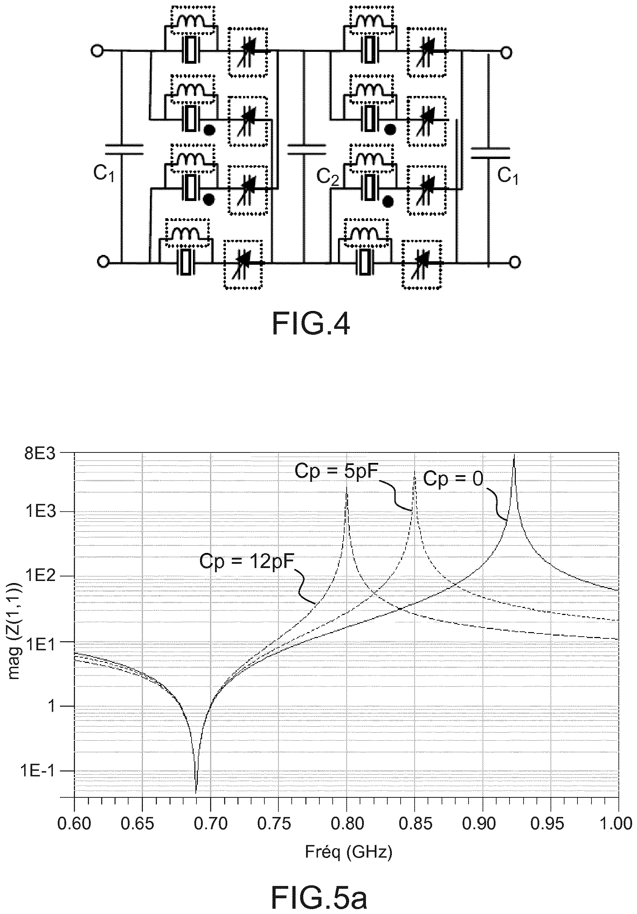

Cependant en 2006 et 2007, cette même équipe démontre qu'avec l'aide d'un circuit actif, il est possible de modifier la fréquence centrale d'un filtre de 0.3%. Ils en concluent que la méthode peut rattraper des dispersions technologiques. Il est possible de présumer que cette méthode a peu de chance de conduire à une véritable agilité du filtre, comme décrit dans l'article de : Razafimandimby, S ; Tilhac, C. ; Cathelin, A. ; Kaiser, A., « An Electronically Tunable Bandpass BAW-Filter for a Zero-IF WCDMA Receiver », (la figure 4 est extraite de cet article) Proceedings of the 32nd European Solid-State Circuits Conference, 2006 (ESSCIRC 2006). , et dans l'article de Cyrille Tilhac, Andreia Cathelin, Andreas Kaiser, Didier Belot, « Digital tuning of an analog tunable bandpass BAW-filter at GHz frequency », 33rd European Solid State Circuits Conference, 2007 (ESSCIRC 2007).

A partir des conclusions de cette étude, la plupart des équipes travaillant sur ce sujet ont cherché des solutions permettant de se passer d'éléments passifs ajoutés à des résonateurs, en se concentrant sur des moyens de modifier la vitesse de propagation des ondes acoustiques.

C'est ainsi que des résonateurs reposant sur l'usage de matériaux électrostrictifs ont été proposés, comme décrit dans l'article de S. Gevorgian, A. Vorobiev, T. Lewin, "DC field and temperature dépendent acoustic résonances in parallel-plate capacitors based on SrTiO3 and Ba0.25Sr0.75TiO3 films: experiment and modeling", Journal of Applied Physics 99, 124112 (2006). Ces matériaux présentent en effet la propriété de présenter une variation de rigidité élastique en fonction d'un champ électrique appliqué. De plus, ils présentent un effet équivalent à la piézoélectricité, mais modulable en intensité, toujours en fonction d'un champ électrique appliqué. Néanmoins, leurs propriétés diélectriques sont également impactées par ce champ électrique, ce qui empêche ces composants de présenter une impédance caractéristique constante. Il a été clairement affirmé que cette variation d'impédance caractéristique rend impossible la synthèse d'un filtre à partir de ce type de résonateurs. De plus, les matériaux présentant ces propriétés, les composés de type BST (Ba$_x$Sr$_{1-x}$TiO$_3$) ou PZT (Pb$_x$Zr$_{1-x}$TiO$_3$) présentent des pertes trop élevées pour produire des résonateurs utilisables dans la pratique.

Une autre solution proposée consiste à réaliser des résonateurs dits composites, reposant sur l'empilement de deux couches piézoélectriques. L'une des couches est connectée au circuit d'utilisation, tandis que l'autre couche est connectée à un circuit d'accord, habituellement une capacité variable permettant de modifier les conditions aux limites électriques que voit l'onde acoustique de volume en se propageant dans l'empilement. Cette structure permet donc de présenter un résonateur agile en fréquence, et uniquement pilotable par une capacité variable, comme décrit dans l'article de R. Aigner, "Tunable acoustic RF-filters: discussion of requirements and potential physical embodiments", Proceedings of the 40th European Microwave Conference, p. 787, 2010. Dans une telle structure, l'obtention de résonateurs présentant un coefficient de couplage électromécanique suffisant pour la synthèse d'un filtre, et une agilité en fréquence suffisante pour couvrir plusieurs bandes de communication, nécessite l'utilisation de matériaux fortement piézoélectriques tels que le niobate de lithium. L'inconvénient de cette structure est cependant qu'elle est extrêmement complexe, et donc couteuse, à réaliser, car nécessitant le cumul de deux couches piézoélectriques. D'autre part, cette structure provoque une simple translation en fréquence du résonateur, mais sans permettre de piloter indépendamment la fréquence de résonance ou d'antirésonance, ce qui peut se montrer problématique dans la mesure où les bandes de télécommunication ne présentent pas toutes la même largeur : on ne peut donc pas simplement translater en fréquence un filtre.

L'approche la plus prometteuse est celle suivie depuis quelques années par une équipe japonaise dirigée par Ken-Ya Hashimoto de l'université de Chiba, abondamment décrite dans les articles suivants : Tomoya Komatsu, Ken-ya Hashimoto, Tatsuya Omori, and Masatsune Yamaguchi, « Tunable Radio-Frequency Filters Using Acoustic Wave Resonators and Variable Capacitors », Japanese Journal of Applied Physics 49 (2010); T. Yasue, T. Komatsu, , N. Nakamura, , K. Hashimoto, « Wideband tunable love wave filter using electrostatically-actuated MEMS variable capacitors integrated on lithium niobate », 16th International Solid-State Sensors, Actuators and Microsystems Conférence (TRANSDUCERS), 2011; Ken-Ya Hashimoto, S. Tanaka, M. Esashi , « Tunable RF SAW/BAW filters: Dream or reality ? », Joint Conférence of the IEEE International Frequency Control and the European Frequency and Time Forum (IFCS), 2011; M. Inaba, K.-Y. Hashimoto, T. Omori, C. Ahn, « A widely tunable filter configuration composed of high Q RF resonators and variable capacitors », European Microwave Integrated Circuits Conférence (EuMIC), 2013, Hideki Hirano, Tetsuya Kimura, Ivoyl P Koutsaroff, Michio Kadota, Ken-ya Hashimoto, Masayoshi Esashi and Shuji Tanaka, « Intégration of BST varactors with surface acoustic wave device by film transfer technology for tunable RF filters », Journal of Micromechanics and Microengineering 2013.

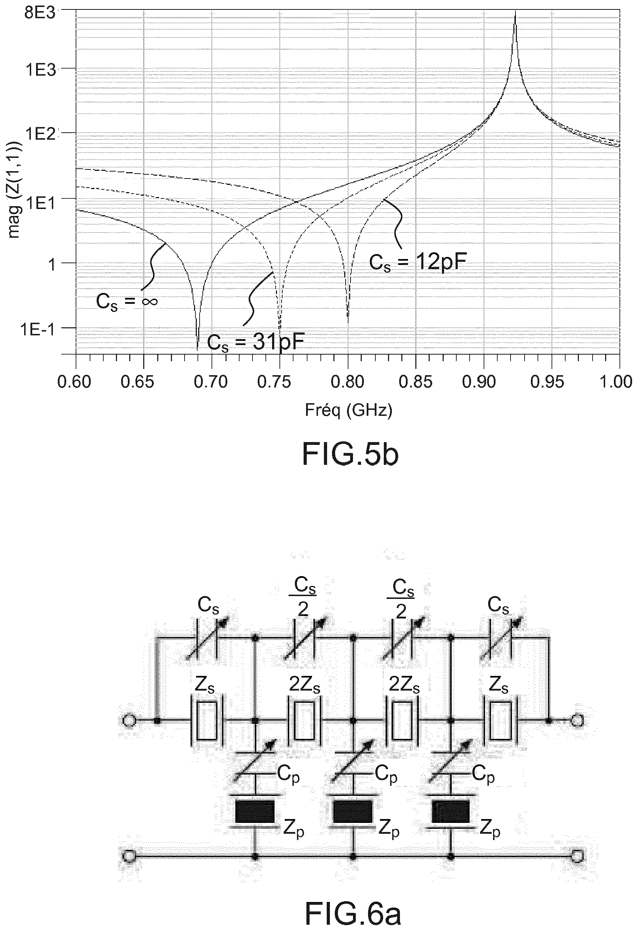

Cette équipe s'emploie à démontrer que la première approche mentionnée ci-dessus est en réalité envisageable, dès lors que l'on dispose de résonateurs réalisés avec des matériaux à très grand coefficient de couplage électromécanique. En effet, l'ajout d'éléments passifs variables en série ou en parallèle à un résonateur acoustique permet de déplacer les fréquences de résonance et d'antirésonance comme illustré sur les figures 5a et 5b qui illustrent l'effet de la capacité en parallèle (variation de la capacité Cp de 0 à 12 pF) et de celui de la capacité en série (variation de la capacité Cs de ∞ à 12 pF) sur la réponse électrique d'un résonateur et plus précisément sur le module de l'impédance exprimée en Ω, et correspondant à la notation mag(Z(1,1)) des figures 5a et 5b. En effet, une capacité en parallèle avec un résonateur vient augmenter la capacité statique du résonateur, provoquant un déplacement du zéro de susceptance du résonateur (c'est-à-dire l'antirésonance) tout en laissant inchangé le pôle (c'est-à-dire la résonance). A l'inverse, l'ajout d'une capacité en série avec un résonateur vient diminuer son impédance caractéristique, et provoque un déplacement du zéro de réactance (c'est-à-dire la résonance) tout en laissant inchangé le pôle (c'est-à-dire l'antirésonance). On est donc capable de déplacer de manière importante les fréquences de résonance et d'antirésonance du résonateur dans les limites de l'intervalle délimité par les fréquences de résonance et d'antirésonance du résonateur d'origine, dépourvu des éléments capacitifs d'ajustement (courbe en traits pleins). Un très grand coefficient de couplage électromécanique devient la condition nécessaire à une très grande agilité en fréquence.

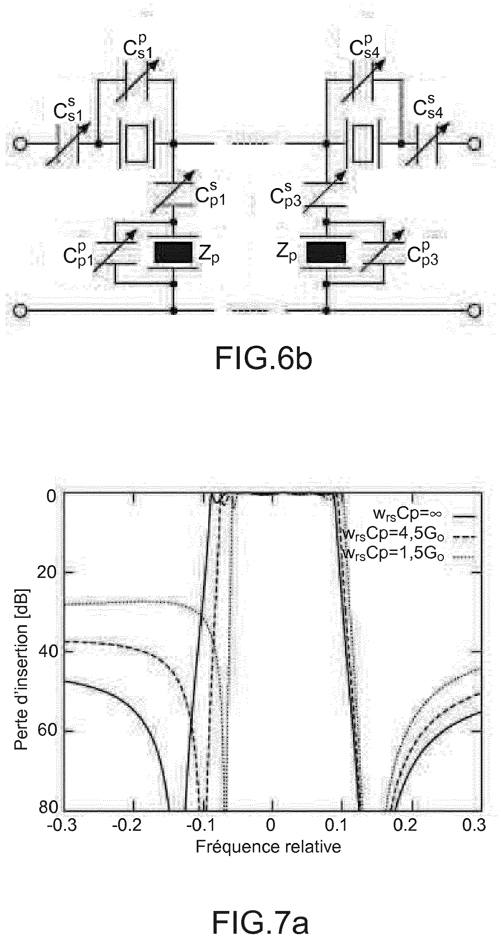

Pour exploiter ce principe, on découvre dès 2010 les topologies illustrées en figure 6a et 6b, décrites dans l'article de Tomoya Komatsu, Ken-ya Hashimoto, Tatsuya Omori, and Masatsune Yamaguchi, « Tunable Radio-Frequency Filters Using Acoustic Wave Resonators and Variable Capacitors », Japanese Journal of Applied Physics 49 (2010), très semblables à ce que les équipes françaises avaient exploré. Les auteurs de cette étude ont en effet pris le parti d'utiliser des composants exploitant des ondes acoustiques de surface présentant un coefficient de couplage électromécanique le plus élevé possible (ici, supérieur à 30 %) en choisissant des substrats de niobate de lithium d'une coupe habituellement non utilisée par les concepteurs de filtres SAW, car présentant des coefficients de couplage électromécanique trop élevés pour permettre une synthèse de filtre de manière classique.

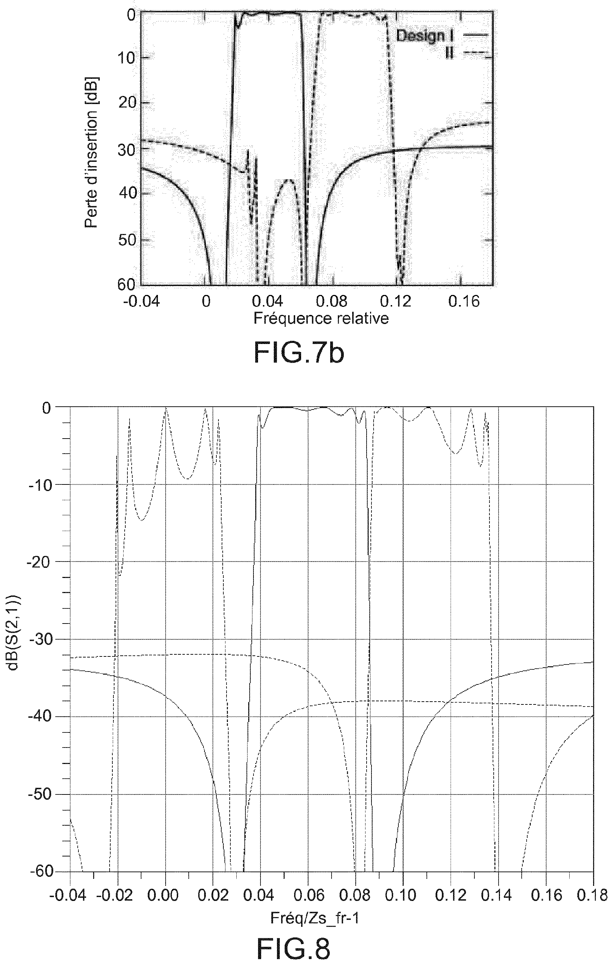

Selon que l'on associe des résonateurs et des capacités, conformément à la topologie de la figure 6a ou de la figure 6b, il est possible, selon les auteurs, d'obtenir le type de réponse illustré respectivement en figures 7a et 7b.

Le filtre de la figure 7a présente une largeur de bande relative d'environ 17%, en s'appuyant sur l'hypothèse d'un matériau piézoélectrique dont le $k^2$ vaut 28%. On peut observer que selon le procédé indiqué en figure 6a, la bande du filtre est réduite sur son bord inférieur tandis que sur son bord supérieur, la bande n'est que très légèrement augmentée. Dans ce cas, on s'emploie donc à réduire la largeur de bande, en déplaçant essentiellement un bord. Ceci conduit donc à modifier également la fréquence centrale effective, avec ici un taux de l'ordre de 3%.

Dans le cas de la figure 7b, les auteurs construisent un filtre de 5% de large, et font varier la fréquence centrale de 5%. On observe donc deux filtres côte à côte. L'agilité proprement dite est donc démontrée : la méthode est fonctionnelle.

Cependant cette solution comporte une forte limite d'exploitation. En effet, les auteurs de l'étude réalisent deux filtres de 5 % de bande, centrés à 4 % et à 9 % de la fréquence de résonance des résonateurs en série. En d'autres termes, ils ne cherchent pas à couvrir l'ensemble du spectre que l'on pourrait supposer exploitable compte tenu du coefficient de couplage de 30 %. Une étude plus poussée de ces travaux montre en effet que très vite, les valeurs des capacités associées sont telles que l'impédance caractéristique du filtre varie de manière si prononcée que son adaptation n'est plus assurée. C'est ce que l'on observe sur la figure 8 (où tous les composants sont supposés sans perte). L'abscisse correspond à une fréquence relative, équivalente à un pourcentage de la résonance naturelle des résonateurs série. Ainsi, la bande du filtre du milieu est centré sur 0.06, soit à 6% de la fréquence de résonance naturelle des résonateurs série.

Le déplacement des résonances et antirésonances sur une large plage de variation (à l'extrême, sur toute la plage autorisée par le coefficient de couplage) suppose l'usage de capacités variables dont les valeurs sont, ou bien très grandes, ou bien très petites devant la capacité naturelle des résonateurs. Dès lors, les conditions d'adaptation ne sont plus observées, et les pertes d'insertion du filtre augmentent. C'est notamment ce que l'on peut observer sur les courbes centrées à 0 % et à 11 %.

La désadaptation provoque également un taux d'onde stationnaire (VSWR) aux entrées/sorties du filtre. Un taux d'onde stationnaire généralement satisfaisant vaut 2, il correspond à un coefficient de réflexion de -10 dB. Beaucoup de systèmes tolèrent un VSWR de 2.5, soit -7.5 dB. Mais les filtres situés sur le chemin de la transmission en puissance sont très stricts, et l'on cherche un VSWR le plus faible possible (le minimum théorique étant 1). Dans les filtres situés à 0 % et 11 % de la figure 8, le VSWR est bien supérieur à 20.

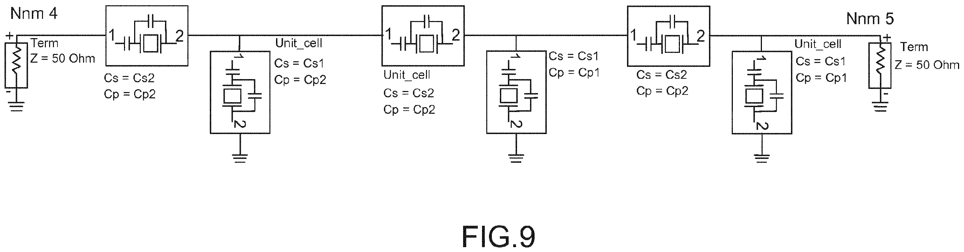

Dans ce contexte et pour mieux appréhender la problématique, les Demandeurs ont étudié plus précisément l'exemple de configuration illustrée en figure 9, qui représente une architecture de filtre en « ladder », représenté entre des références Num4 et Num5.

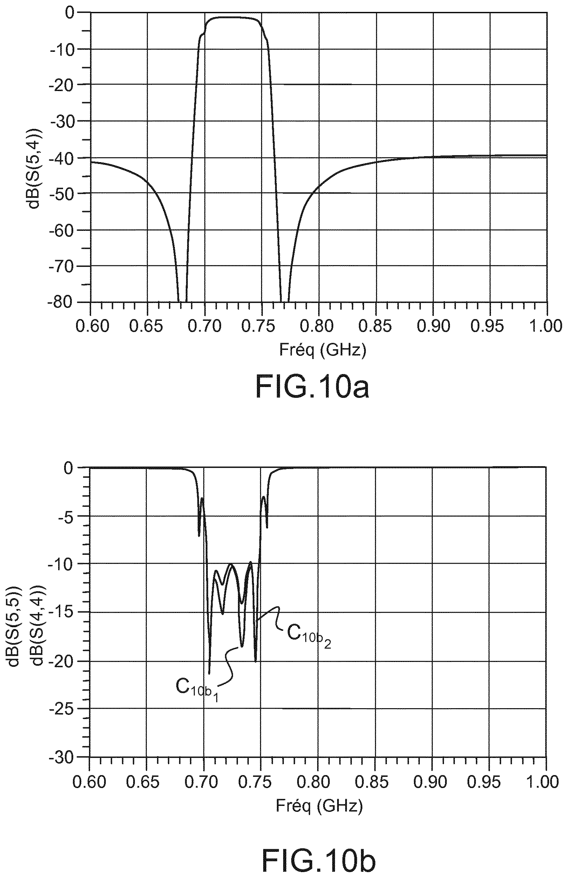

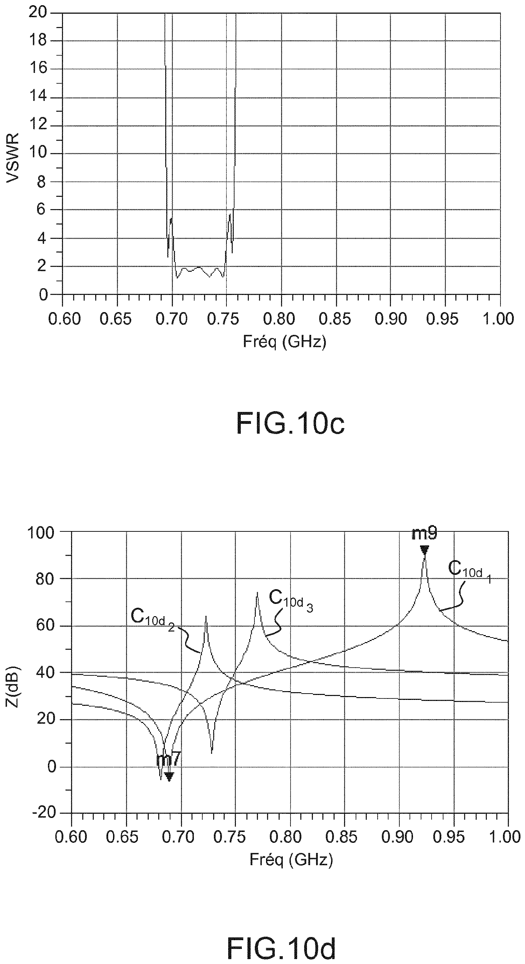

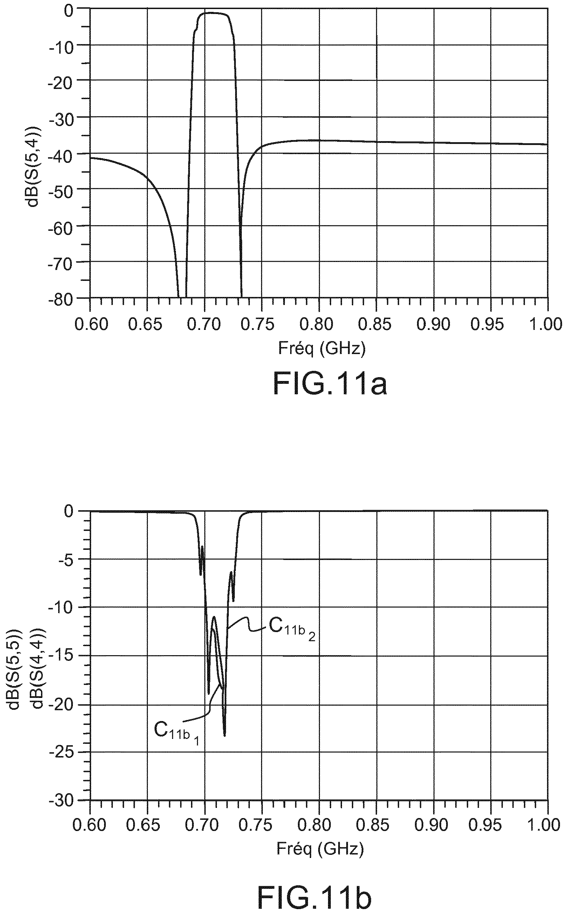

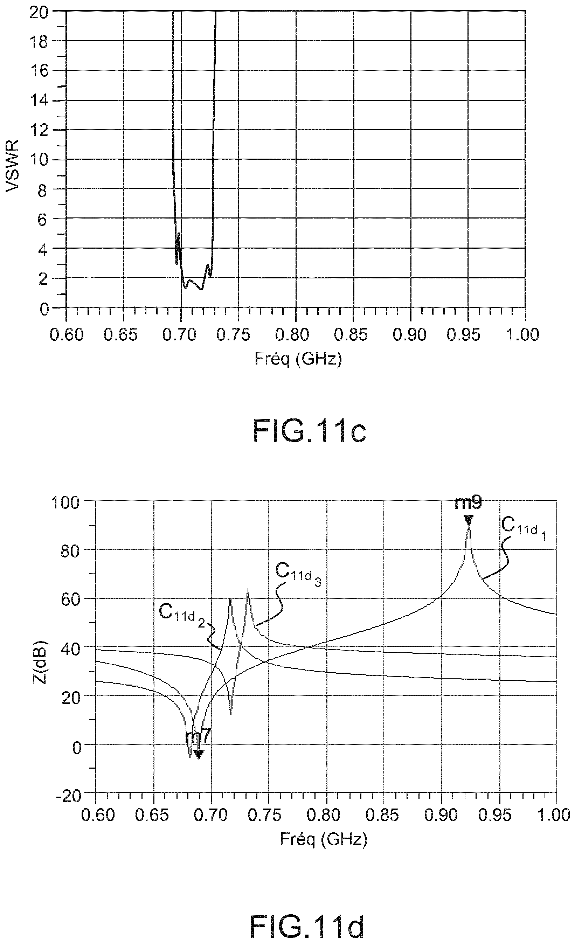

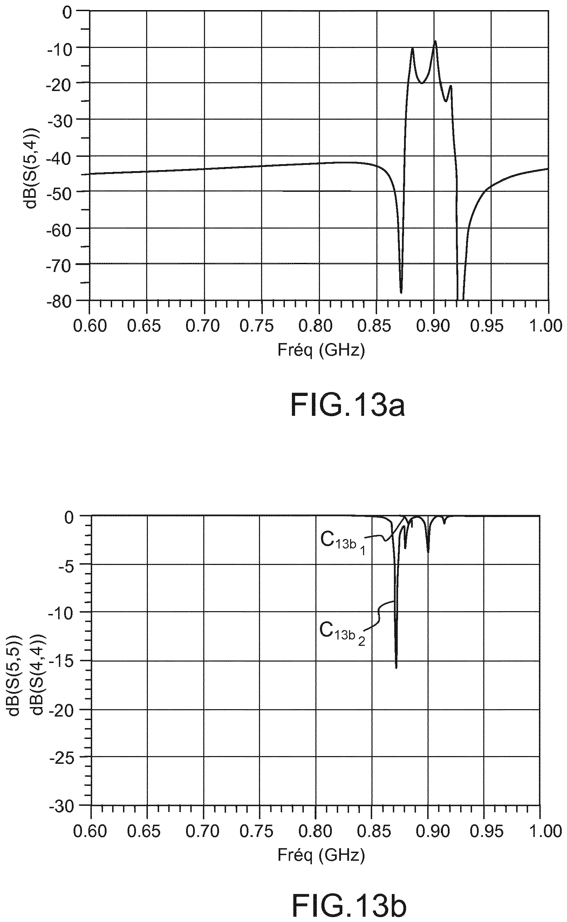

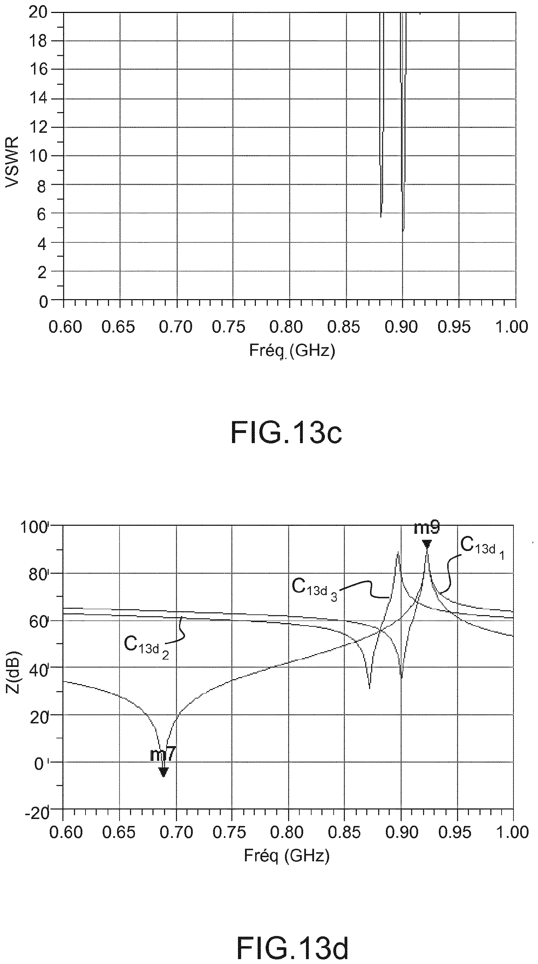

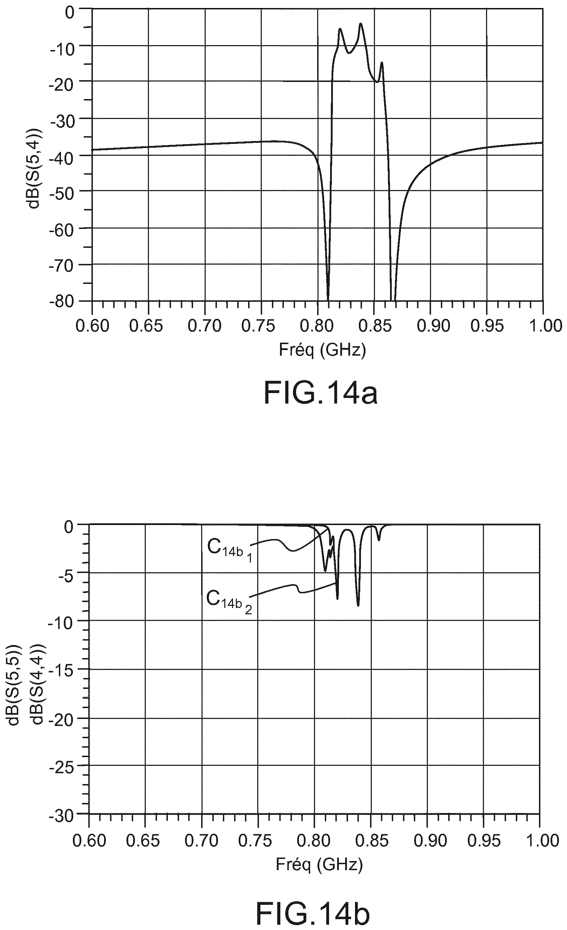

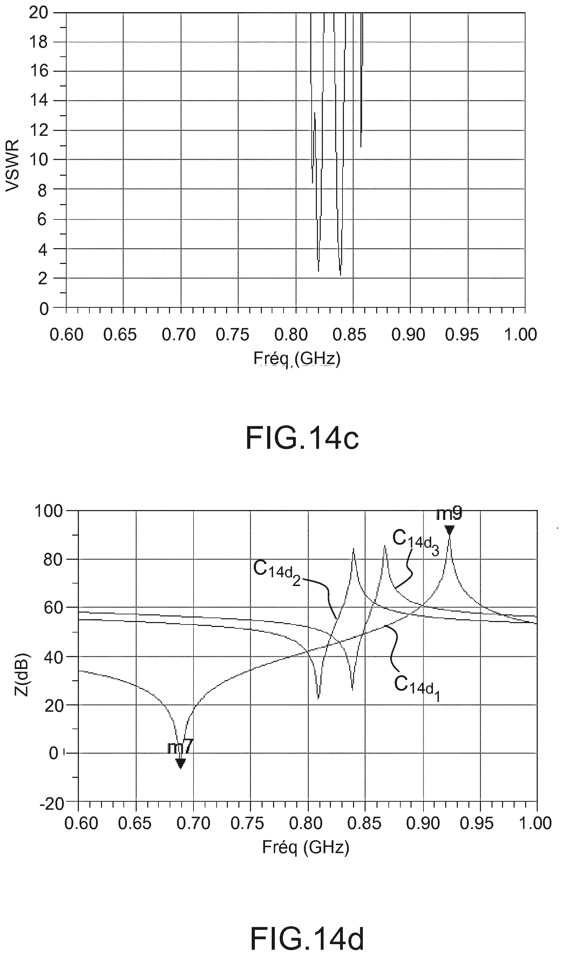

A partir de cette architecture, les Demandeurs ont cherché à adresser plusieurs bandes de fréquences : les bandes TX numérotés 28, 17, 13, 8 et 5 du protocole LTE, ces bandes étant respectivement présentées sur les figures 10, 11, 12, 13 et 14. Leur couverture simultanée nécessite un filtre capable de se déplacer sur une plage de fréquence s'étendant de 734 à 960 MHz, et réalisé à partir d'un unique résonateur : seules les capacités séries et parallèles évoluent d'une bande à l'autre. Le résonateur a été dimensionné de manière optimale (c'est-à-dire pour adapter le filtre au générateur et à la charge) sur la bande 28 (758-803 MHz):

- les figures 10a, 11a, 12a, 13a et 14a sont relatives à la réponse en transmission du filtre ($S_{21}$ ou $S_{12}$) ;
- les figures 10b, 11b, 12b, 13b et 14b sont relatives à la réponse en réflexion du filtre ($S_{11}$ ou $S_{22}$), plus précisément :

    ◦ les courbes $C_{10b1}$, $C_{11b1}$, $C_{12b1}$, $C_{13b1}$ et $C_{14b1}$ sont relatives à la réponse S(4,4) en réflexion exprimée en dB du filtre illustré en figure 9 ;
    ◦ les courbes $C_{10b2}$, $C_{11b2}$, $C_{12b2}$, $C_{13b2}$ et $C_{14b2}$ sont relatives à la réponse S(5,5) en réflexion du filtre exprimée en dB illustré en figure 9 ;

- les figures 10c, 11c, 12c, 13c et 14c sont relatives au taux d'onde stationnaire (VSWR), calculé au port Num4 ;
- les figures 10d, 11d, 12d, 13d et 14d montrent :

    ◦ les courbes $C_{10d1}$, $C_{11d1}$, $C_{12d1}$, $C_{13d1}$ et $C_{14d1}$ relatives à l'impédance du résonateur dit « relaxé », c'est-à-dire sans aucune capacité variable, fixée par ses dimensions et les caractéristiques technologiques de la couche piézoélectrique ;
    ◦ les courbes $C_{10d2}$, $C_{11d2}$, $C_{12d2}$, $C_{13d2}$ et $C_{14d2}$ relatives à la réponse en impédance de la brique parallèle, constituée du résonateur « relaxé » et des capacités associées ;
    ◦ les courbes $C_{10d3}$, $C_{11d3}$, $C_{12d3}$, $C_{13d3}$ et $C_{14d3}$ relatives à la réponse de la brique série, constituée d'un résonateur identique à la brique parallèle, et de capacités associées différentes de celles de la brique parallèle.

Les points m7 et m9 sont respectivement relatifs à des fréquences de 689MHz et 923MHz et présentent des impédances respectives de -6,5 dB et 90 dB.

On constate, comme anticipé par l'état de l'art antérieur, que lorsqu'on définit un résonateur optimal pour la bande 28, il est possible de parvenir par exemple à réaliser la bande 17 (734-746 MHz), tandis que les autres bandes ne peuvent être réalisées dans des conditions correctes, c'est-à-dire avec un taux d'onde stationnaire de l'ordre de 2.

Les Demandeurs ont également mené l'étude en choisissant un résonateur optimal pour le centre de la plage de variation, c'est-à-dire centré sur 800 MHz (permettant un fonctionnement optimal en bande 13 et trois fois plus gros que celui calibré pour la bande 28) : on parvient à la même conclusion. Les conclusions seraient les mêmes en partant d'une optimisation sur la bande la plus élevée en fréquence.

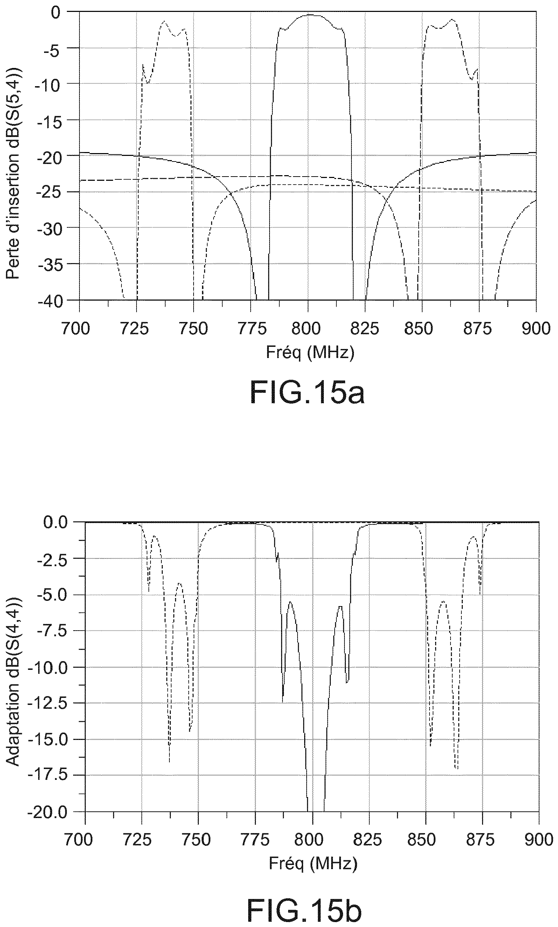

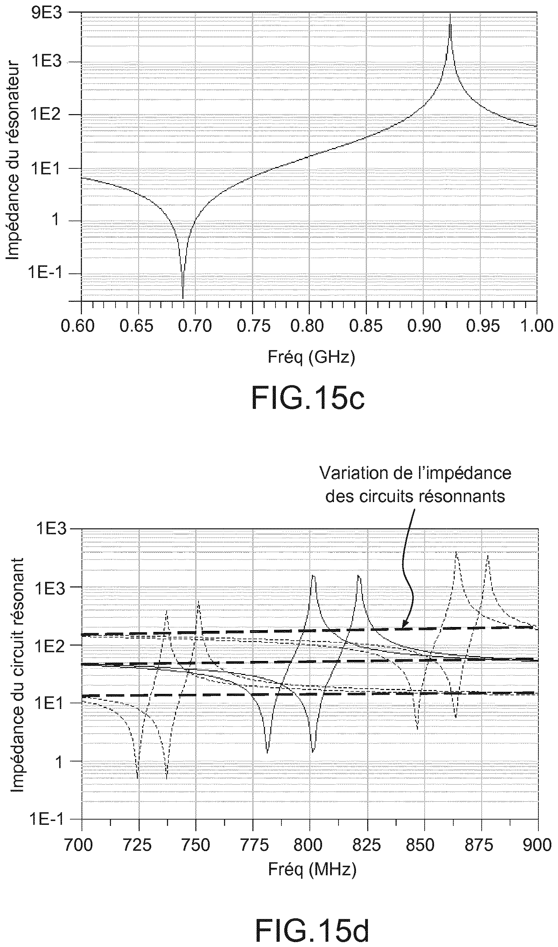

Les figures 15a, 15b, 15c et 15d sont respectivement relatives aux pertes d'insertion, à l'adaptation, à l'impédance (sans capacité série et sans capacité parallèle) et à l'impédance des couples de circuits résonants (avec des valeurs de capacité série et de capacité parallèle variables) pour un filtre variable centré autour de 800MHz. Il apparait clairement en figure 15d, un problème de variation d'impédance pour les différentes courbes, relatives à un déplacement en fréquence d'environ 60 MHz autour de la fréquence centrale de 800 MHz.

La contrainte ne vient pas de la fréquence de travail, mais de la plage de fréquence que l'on cherche à couvrir, et de la largeur de bande de chaque filtre que l'on cherche à réaliser.

L'observation des courbes des impédances des résonateurs montre que lorsqu'on se déplace en fréquence, de la fréquence de résonance série à la fréquence de résonance parallèle du résonateur « relaxé », l'impédance caractéristique du circuit résonant augmente. Les circuits résonants du filtre centré à 800MHz présentent une impédance caractéristique d'environ 50 Ohms, tandis qu'ils varient à environ 10 Ohms et environ 200 Ohms, respectivement à -60MHz et à +60MHz. Cette dispersion d'impédance caractéristique constitue la cause principale des limitations de l'approche.

Il est également connu de manière générale, du Document US 2007/296513 ou du Document US 2012/313731 des circuits résonants comprenant des groupes de N résonateurs ayant la même fréquence de résonance et la même fréquence d'antirésonance.

C'est pourquoi et dans ce contexte, les Demandeurs proposent une nouvelle solution permettant de stabiliser l'impédance caractéristique d'un circuit résonant comprenant un résonateur à une valeur choisie et permettant notamment de réaliser des filtres à fréquence centrale ajustable et à bande également ajustable, tout en assurant leur adaptation d'impédance.

La description ci-après explicite le raisonnement inventif mené par les Demandeurs qui leur a permis de concevoir la solution de la présente invention.

Partant des problèmes précités des solutions de l'art antérieur, les Demandeurs ont exploré une voie à l'encontre de l'état de l'art et plutôt que de faire varier les capacités associées à un résonateur fixe, les Demandeurs ont étudié le fonctionnement d'un filtre BAW construit à partir d'un résonateur (simple couche) à surface (et donc à capacité statique) variable, et à capacités associées fixes, même si la variation de la capacité statique d'un résonateur piézoélectrique n'est pas un paramètre qui s'impose de manière directe. En effet, la surface ou l'épaisseur d'un résonateur sont figées par la technologie, il s'agit des dimensions physiques du composant. Cette possibilité est pourtant disponible pour les résonateurs électrostrictifs mentionnés dans l'art antérieur, bien qu'accompagnés d'autres effets contraignants.

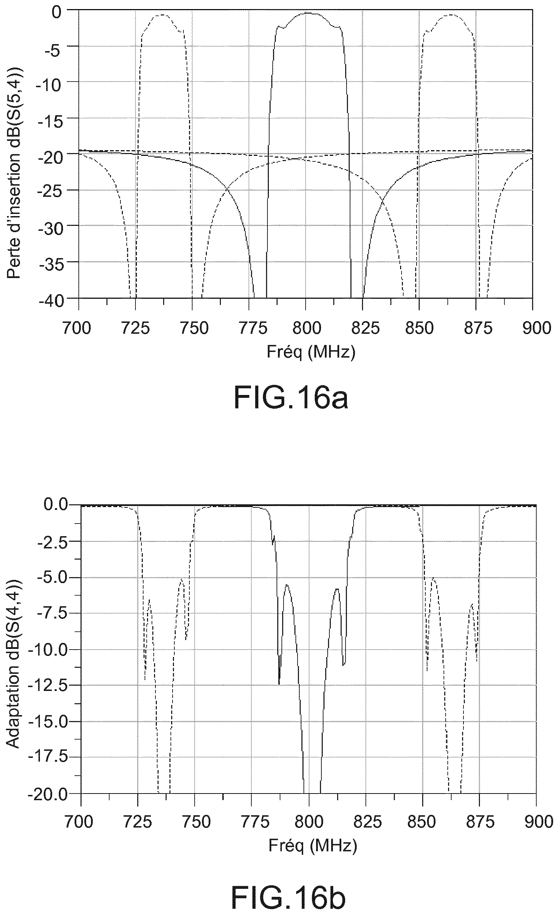

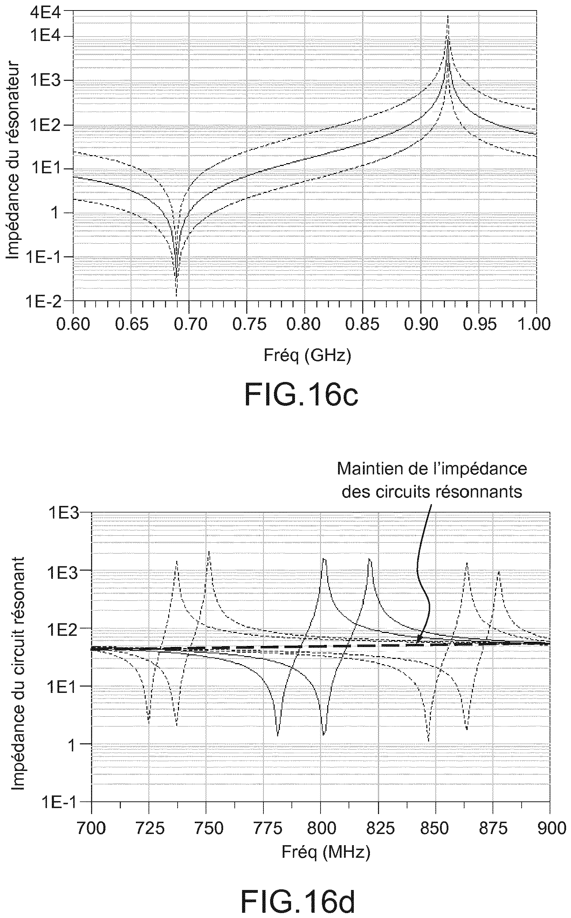

Ainsi à partir de la topologie illustrée en figure 9 et en fixant les capacités associées aux valeurs correspondant à l'optimal de la bande 13, les Demandeurs ont étudié le comportement en changeant désormais uniquement la surface du résonateur. On obtient alors les résultats des figures 16a, 16b, 16c et 16d pour des résonateurs évoluant de 50 $\mu$m à 300 $\mu$m de côté. Les figures 16a, 16b, 16c et 16d sont respectivement relatives aux pertes d'insertion, à l'adaptation, à l'impédance (sans capacité série et sans capacité parallèle) et à l'impédance des couples de dispositifs résonants (avec des valeurs de capacité série et de capacité parallèle fixées) :

- la figure 16a montre clairement un maintien des pertes d'insertion ;
- la figure 16b montre clairement un maintien de l'adaptation ;
- la figure 16c montre clairement la variation de l'impédance caractéristique en fonction de la surface ;
- la figure 16d montre clairement un maintien de l'impédance caractéristique des couples de circuits résonants.

Le résonateur dit « relaxé » le plus petit se situe à plus basse fréquence, tandis que le résonateur « relaxé » le plus gros se situe à plus haute fréquence. On observe que la réponse du dispositif est telle qu'on obtient un filtre de 20 MHz environ (soit 2.5 % de largeur de bande à 800 MHz), et adapté de 725 MHz à 875 MHz, soit plus de 18 % autour de 800 MHz. Par ailleurs, le tracé de l'impédance des résonateurs séries et parallèles montrent qu'ils présentent tous la même impédance caractéristique, située autour de 50 Ohms. La figure 16d est remarquable prouvant cette stabilité d'impédance.

Enfin il est très intéressant de constater également que le positionnement relatif des fréquences remarquables des résonateurs séries et parallèles est conservé, quelle que soit la surface de résonateur « relaxé » choisi.

Le filtre ainsi réalisé a donc la propriété d'être à largeur de bande fixe, et à fréquence centrale variable.

Les Demandeurs ont ainsi mis en évidence qu'il devient possible d'obtenir avec une brique élémentaire simple (simple couche de matériau) présentant un fort coefficient de couplage (par exemple avec des matériaux tels que le niobate de lithium (LiNbO$_3$, ou LNO) ou bien encore le niobate de potassium (KNbO$_3$)) et une impédance variable, ce qui était proposé dans l'art antérieur avec des résonateurs composites comme décrit dans l'article de A. Reinhardt, E. Defaÿ, F. Perruchot, C. Billard, "Tunable composite piezoelectric resonators: a possible 'Holy Grail' of RF filters ?", Proceedings of the International Microwave Symposium, 2012.

Par ailleurs, ce nouveau « résonateur à impédance variable » peut également être associé à un composant réactif variable en série et un autre en parallèle. Cette association permet en effet d'avoir une complète liberté sur le positionnement fréquentiel de la résonance, de l'antirésonance, et de l'impédance de l'ensemble. On obtient donc la possibilité de réaliser des filtres à largeur de bande variable, et à fréquence centrale variable.

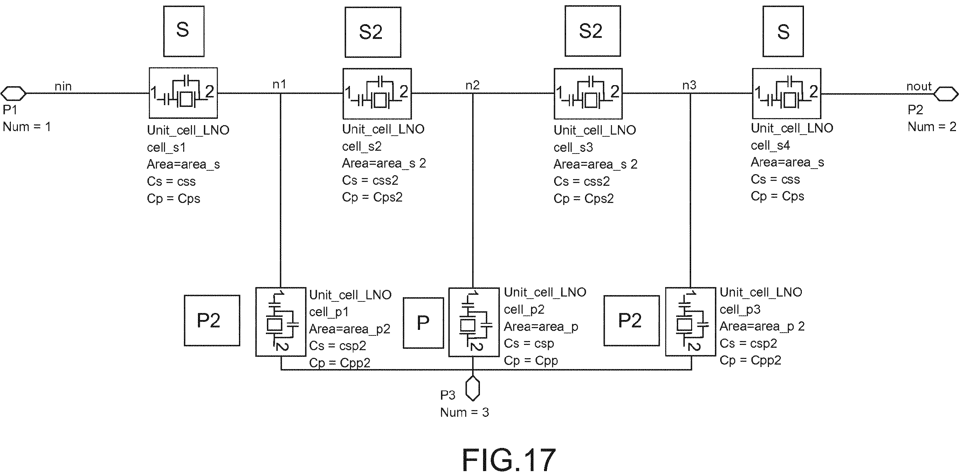

Ainsi, à partir de la topologie de filtrage commune à toute bande située entre 700 MHz et 850 MHz, et par exemple les bandes TX 28, 17, 13 et 5, illustrée en figure 17, les Demandeurs ont fait la démonstration qu'il est notamment possible de construire par exemple les filtres adressant les bandes TX numérotées 28, 17, 13 et 5, et respectant les spécifications propres à une possible réalisation de 4 duplexeurs en un, et ceci en ajustant la surface de chaque résonateur, ainsi que les capacités associées en série et en parallèle.

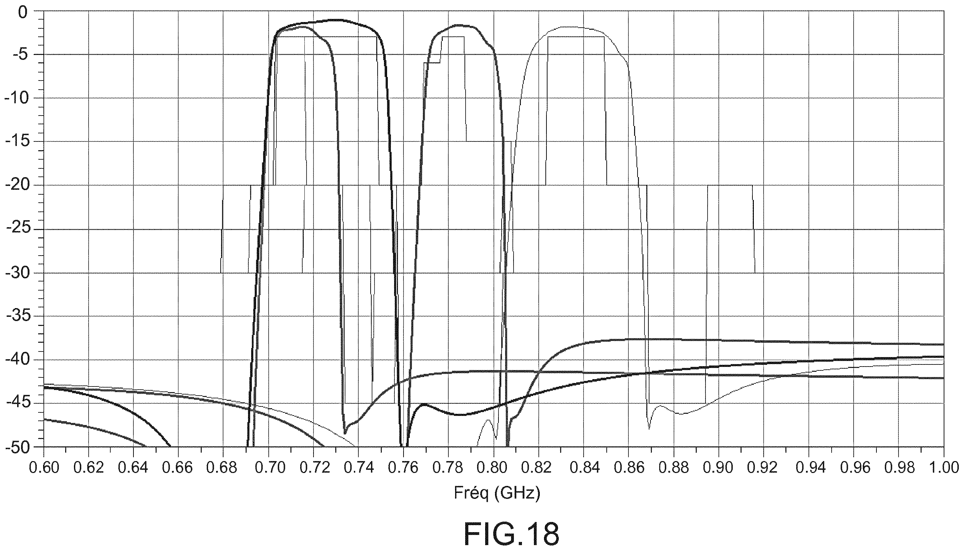

Plus précisément, le tableau suivant fait le bilan de toutes les valeurs de surface, de capacités série et de capacités parallèles, mises en oeuvre au sein de la topologie représentée en figure 17, pour réaliser les fonctions de filtrages illustrées en figure 18, configurée pour les bandes TX 28, 17, 13 et 5.

| Band 28 | | Band 13 | |
|---|---|---|---|
| P = 70x70µm<br>$C_s(P) = \infty$<br>$C_p(P) = 6{,}7$ pF | P2 = 80x80µm<br>$C_s(P2) = \infty$<br>$C_p(P2) = 7{,}5$ pF | P = 250x250µm<br>$C_s(P) = 15{,}2$ pF<br>$C_p(P) = 18$ pF | P2 = 250x250µm<br>$C_s(P2) = 15{,}5$ pF<br>$C_p(P2) = 18$ pF |
| S = 105x105µm<br>$C_s(S) = 11{,}8$ pF<br>$C_p(S) = 6{,}8$ pF | S2 = 55x55µm<br>$C_s(S2) = 4{,}2$ pF<br>$C_p(S2) = 1{,}4$ pF | S = 200x200µm<br>$C_s(S) = 4{,}8$ pF<br>$C_p(S) = 10{,}3$ pF | S2 = 150x150µm<br>$C_s(S2) = 2{,}6$ pF<br>$C_p(S2) = 5{,}8$ pF |
| **Band 17** | | **Band 5** | |
| P = 100x100µm<br>$C_s(P) = \infty$<br>$C_p(P) = 12{,}1$ pF | P2 = 100x100µm<br>$C_s(P2) = \infty$<br>$C_p(P2) = 14$ pF | P = 300x300µm<br>$C_s(P) = 11{,}1$ pF<br>$C_p(P) = 11{,}9$ pF | P2 = 300x300µm<br>$C_s(P2) = 11{,}2$ pF<br>$C_p(P2) = 12{,}1$ pF |
| S = 70x70µm<br>$C_s(S) = 5{,}7$ pF<br>$C_p(S) = 5{,}2$ pF | S2 = 50x50µm<br>$C_s(S2) = 2{,}8$ pF<br>$C_p(S2) = 2{,}4$ pF | S = 180x180µm<br>$C_s(S) = 3{,}7$ pF<br>$C_p(S) = 2{,}1$ pF | S2 = 125x125µm<br>$C_s(S2) = 1{,}7$ pF<br>$C_p(S2) = 1{,}1$ pF |

Les Demandeurs ont ainsi pu démontrer qu'avec l'aide d'un même empilement technologique, et de la même topologie, il est possible de réaliser notamment les filtres RX de ces mêmes bandes 28, 17, 13 et 5.

L'approche décrite précédemment prouve qu'avec la présente invention, il devient possible de concevoir notamment un filtre reconfigurable couvrant n'importe quelle bande de fréquence située entre 700 et 900 MHz, soit une couverture fréquentielle de 25%.

C'est pourquoi et de manière générale, la présente invention a pour objet un circuit résonant, à impédance caractéristique stabilisée comprenant une borne d'entrée (Pe) et une borne de sortie (Ps) et au moins :

- un groupe de N résonateurs piézoélectriques avec N >1, lesdits résonateurs ayant la même fréquence de résonance et la même fréquence d'antirésonance, lesdits résonateurs étant disposés en parallèle de manière que la somme de leurs capacités statiques élémentaires est égale à une capacité statique dudit groupe ;
- un premier élément d'adaptation d'impédance (Cs) présentant une réactance non nulle et un second élément d'adaptation d'impédance (Cp) présentant une réactance non nulle, le premier élément d'adaptation d'impédance étant en série avec ledit groupe de N résonateurs, et le second élément d'adaptation d'impédance étant en parallèle avec ledit groupe de N résonateurs,

ledit circuit résonant comprenant :

- des premiers moyens de commande dudit groupe de résonateurs agencés pour permettre de fixer la capacité statique ($C_0$) dudit groupe à une première valeur ;
- des seconds moyens de commande agencés pour permettre de fixer l'impédance du premier élément d'adaptation d'impédance et celle du second élément d'adaptation d'impédance égales à des secondes valeurs ; lesdites première et secondes valeurs étant telles que :

- le triplet de valeurs : capacité statique dudit groupe / impédance du premier élément d'adaptation d'impédance/ impédance du second élément d'adaptation d'impédance ($C_0$, Cs, Cp) détermine, pour l'impédance $\overline{Z}$ de l'ensemble constitué par ledit groupe, ledit premier élément d'adaptation d'impédance et ledit second élément d'adaptation, un triplet de paramètres suivants :

  ○ une impédance caractéristique $\overline{Z_c}$ dudit ensemble ;
  ○ la fréquence de résonance $\overline{\omega_r}$ dudit ensemble ;
  ○ la fréquence d'antirésonance $\overline{\omega_a}$ dudit ensemble ;

pour stabiliser l'impédance caractéristique dudit circuit à une impédance caractéristique choisie.

Dans le cadre de l'invention, ledit ensemble constitué par ledit groupe, ledit premier élément d'adaptation d'impédance et ledit second élément d'adaptation présente l'impédance d'un modèle de Butterworth-Van Dyke (BVD).

Selon des variantes de l'invention, ledit groupe de N résonateurs étant constitué de plusieurs résonateurs Ri, lesdits premiers moyens de commande comprennent un circuit de commutation permettant de sélectionner et de relier un ou plusieurs résonateurs.

Selon des variantes de l'invention, les résonateurs sont des résonateurs à ondes de volume (BAW) pouvant présenter des dimensions géométriques différentes.

Selon des variantes de l'invention, les résonateurs sont des résonateurs à ondes de surface (SAW), pouvant comporter des agencements d'électrodes différents à la surface d'un substrat piézoélectrique.

Selon une alternative qui ne fait pas partie de l'invention, le nombre N étant égal à 1, ledit résonateur présente une capacité variable dont la valeur est fonction de la valeur d'un signal électrique de commande, lesdits premiers moyens comportant des moyens pour faire varier ledit signal électrique de commande.

Ledit résonateur selon ladite alternative qui ne fait pas partie de l'invention peut-être un résonateur électrostrictif à base de matériau BST.

Selon des variantes de l'invention, au moins un élément d'adaptation d'impédance est un condensateur, une inductance ou un ensemble d'éléments passifs.

Selon des variantes de l'invention, au moins un élément d'adaptation d'impédance est un circuit actif pouvant comprendre des transistors.

Selon des variantes de l'invention, le second élément d'adaptation d'impédance est placé entre les bornes d'entrée et de sortie, monté en parallèle de l'ensemble suivant : groupe de résonateurs/ premier élément d'adaptation d'impédance placés en série.

Selon des variantes de l'invention, le circuit résonant comprend :

- une première puce comprenant au moins lesdits premiers moyens de commande pour fixer la capacité statique dudit groupe à une première valeur ;
- une seconde puce comprenant ledit groupe de résonateurs ;
- des moyens d'interconnexion desdits premiers moyens de commande avec ledit groupe de résonateurs.

Selon des variantes de l'invention, la première puce comporte en outre les premier et second éléments d'adaptation d'impédance.

Selon des variantes de l'invention, la seconde puce comporte en outre les premier et second éléments d'adaptation d'impédance.

L'invention a aussi pour objet un filtre comprenant un ensemble de circuits résonants selon l'invention.

L'invention a encore pour objet un duplexeur comprenant un ensemble de circuits résonants selon l'invention.

L'invention a également pour objet un dispositif comprenant un ensemble d'au moins deux circuits résonants selon l'invention et présentant une impédance d'entrée et une impédance de sortie, compris entre un port d'entrée et un port de sortie, caractérisé en ce qu'il comprend :

- des premiers moyens de commande de groupe de résonateurs et des seconds moyens de commande des premiers et seconds éléments d'adaptation d'impédance pour régler :

  ○ l'impédance caractéristique de chacun desdits circuits ;
  ○ les fréquences de résonance et d'antirésonance de chacun desdits circuits.

L'invention a également pour objet un dispositif comprenant un ensemble d'au moins deux circuits résonants selon l'invention, caractérisé en ce que lesdits premiers moyens de commande de groupe de résonateurs et lesdits seconds moyens de commande des premiers et seconds éléments d'adaptation d'impédance sont agencés pour permettre de fixer les triplets de valeurs : capacité statique dudit groupe / impédance du premier élément d'adaptation d'impédance/ impédance du second élément d'adaptation d'impédance pour :

- ◦ régler les valeurs d'impédances caractéristiques des deux circuits résonants à des valeurs fixées ;
- ◦ faire varier les fréquences de résonance et d'antirésonance des deux circuits résonants.

L'invention a également pour objet un dispositif comprenant un ensemble d'au moins deux circuits résonants selon l'invention, caractérisé en ce que lesdits premiers moyens de commande de groupe de résonateurs et lesdits seconds moyens de commande des premiers et seconds éléments d'adaptation d'impédance sont agencés pour permettre de fixer les triplets de valeurs : capacité statique dudit groupe / impédance du premier élément d'adaptation d'impédance/ impédance du second élément d'adaptation d'impédance pour :

- ◦ faire varier les valeurs d'impédances caractéristiques des deux circuits résonants ;
- ◦ régler les fréquences de résonance et d'antirésonance des deux circuits résonants à des valeurs fixées.

L'invention sera mieux comprise et d'autres avantages apparaîtront à la lecture de la description qui va suivre donnée à titre non limitatif et grâce aux figures annexées parmi lesquelles :

- les figures 1a, 1b et 1c illustrent respectivement un empilement classique de résonateur BAW, le schéma équivalent et les fréquences de résonance et d'antirésonance d'un tel résonateur ;
- la figure 2 illustre la réponse d'un filtre constitué de résonateurs acoustiques ;
- la figure 3 illustre un exemple de topologie pour un duplexeur UMTS à base de résonateurs BAW ;
- la figure 4 illustre une topologie de l'art connu proposant d'associer des résonateurs et des capacités variables ;
- les figures 5a et 5b illustrent l'effet d'une capacité montée en parallèle et celui d'une capacité montée en série sur la réponse électrique d'un résonateur ;
- les figures 6a et 6b illustrent des exemples de l'art connu de topologie associant des capacités variables en série et en parallèle avec des résonateurs ;
- les figures 7a et 7b illustrent l'évolution des pertes en fonction de la fréquence pour les deux exemples illustrés en figures 6a et 6b ;
- la figure 8 illustre la réponse en termes de désadaptation de filtres lorsqu'ils sont centrés à 0% et à 11% de la résonance des résonateurs en série, selon la topologie illustrée en figure 7b ;
- la figure 9 illustre un exemple d'architecture de filtre en « ladder » ;
- les figures 10a, 11a, 12a, 13a et 14a sont relatives à la réponse en transmission du filtre ($S_{21}$ ou $S_{12}$) illustré en figure 9 ;
- les figures 10b, 11b, 12b, 13b et 14b montrent pour le filtre illustré en figure 9 :

    - ◦ les courbes $C_{10b1}$, $C_{11b1}$, $C_{12b1}$, $C_{13b1}$ et $C_{14b1}$ sont relatives à la réponse S(4,4) en réflexion exprimée en dB du filtre illustré en figure 9 ;
    - ◦ les courbes $C_{10b2}$, $C_{11b2}$, $C_{12b2}$, $C_{13b2}$ et $C_{14b2}$ sont relatives à la réponse S(5,5) en réflexion du filtre exprimée en dB illustré en figure 9 ;

- les figures 10c, 11c, 12c, 13c et 14c sont relatives au taux d'onde stationnaire (VSWR) calculé au noeud Num4 illustré en figure 9 ;
- les figures 10d, 11d, 12d, 13d et 14d montrent, pour le filtre illustré en figure 9 :

    - ◦ les courbes $C_{10d1}$, $C_{11d1}$, $C_{12d1}$, $C_{13d1}$ et $C_{14d1}$ relatives à l'impédance du résonateur dit « relaxé », c'est-à-dire sans aucune capacité variable, fixée par ses dimensions et les caractéristiques technologiques de la couche piézoélectrique ;
    - ◦ les courbes $C_{10d2}$, $C_{11d2}$, $C_{12d2}$, $C_{13d2}$ et $C_{14d2}$ relatives à la réponse en impédance de la brique parallèle, constituée du résonateur « relaxé » et des capacités associées ;
    - ◦ les courbes $C_{10d3}$, $C_{11d3}$, $C_{12d3}$, $C_{13d3}$ et $C_{14d3}$ relatives à la réponse de la brique série, constituée d'un résonateur identique à la brique parallèle, et de capacités associées différentes de celles de la brique parallèle ;

- les figures 15a, 15b, 15c et 15d sont respectivement relatives aux pertes d'insertion, à l'adaptation, à l'impédance (sans capacité série et sans capacité parallèle) et à l'impédance des couples de circuits résonants (avec des valeurs de capacité série et de capacité parallèle variables) ;
- les figures 16a, 16b, 16c et 16d sont respectivement relatives à des réponses superposées d'un même filtre dont la surface des résonateurs varie et respectivement aux pertes d'insertion, à l'adaptation, à l'impédance (sans capacité série et sans capacité parallèle) et à l'impédance des couples de circuits résonants (avec des valeurs de capacité série et de capacité parallèle fixées) ;

- la figure 17 illustre un exemple de topologie de filtre pouvant être utilisée dans différentes bandes de fréquences ;
- la figure 18 illustre la réponse fréquentielle de la topologie représentée en figure 17 ;

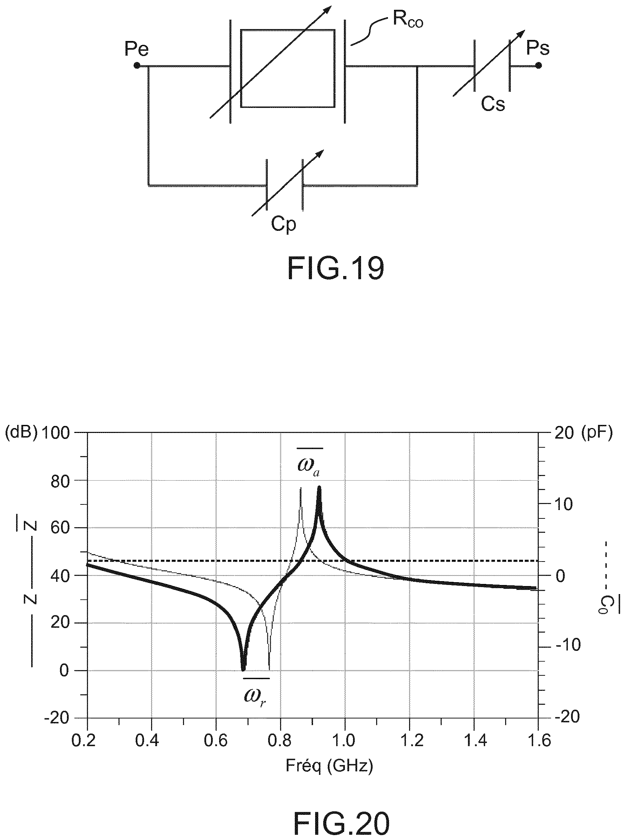

- la figure 19 schématise un premier exemple de circuit résonant de l'invention ;
- la figure 20 illustre l'impédance d'un résonateur et l'impédance caractéristique du circuit résonant selon l'invention utilisant ledit résonateur ;

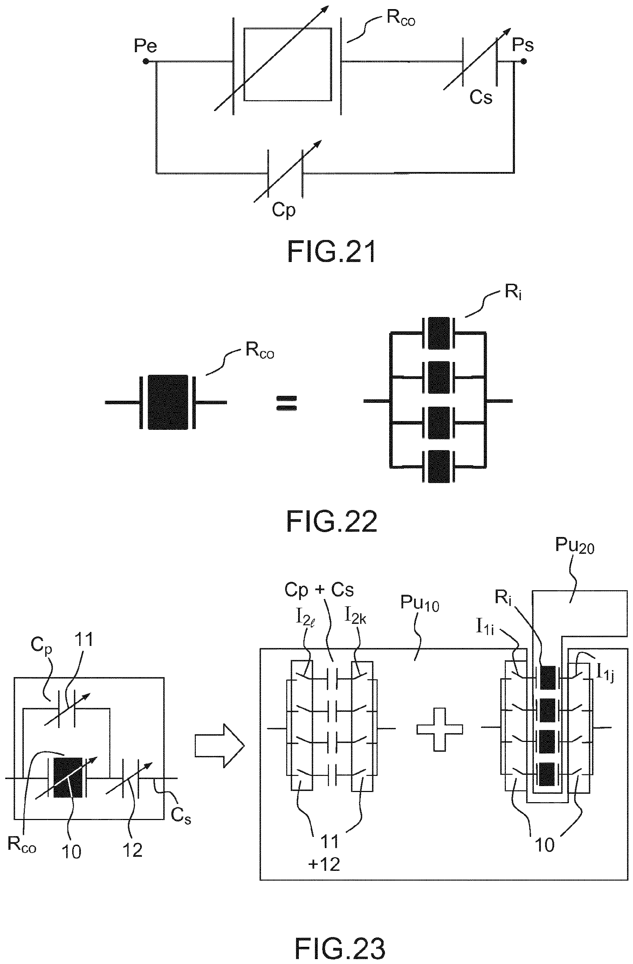

- la figure 21 schématise un second exemple de circuit résonant de l'invention ;
- la figure 22 illustre l'équivalence d'un grand résonateur et d'un ensemble de petits résonateurs disposés en parallèle ;
- la figure 23 illustre un premier mode de réalisation comprenant des moyens de commande sélective d'un sous-ensemble de résonateurs dans la série de résonateurs schématisée en figure 22 et des moyens de commande des éléments réactifs, et associant deux puces comprenant les résonateurs et les moyens de commande ;

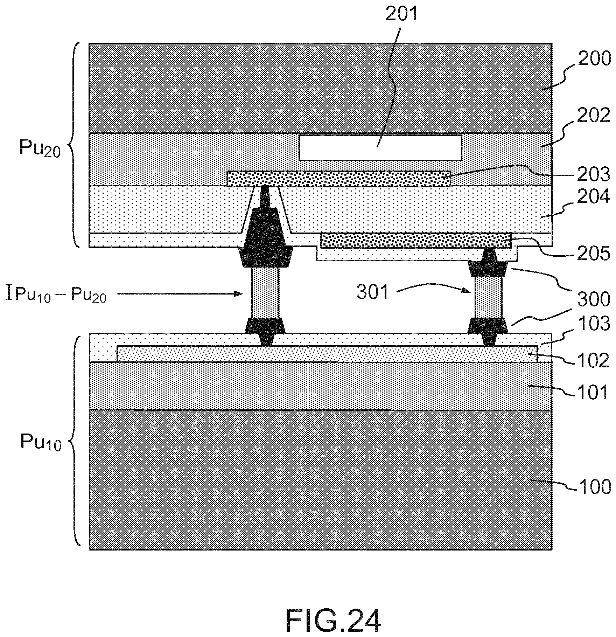

- la figure 24 illustre en détails un exemple de moyens d'interconnexion entre deux puces illustrées en figure 23 ;

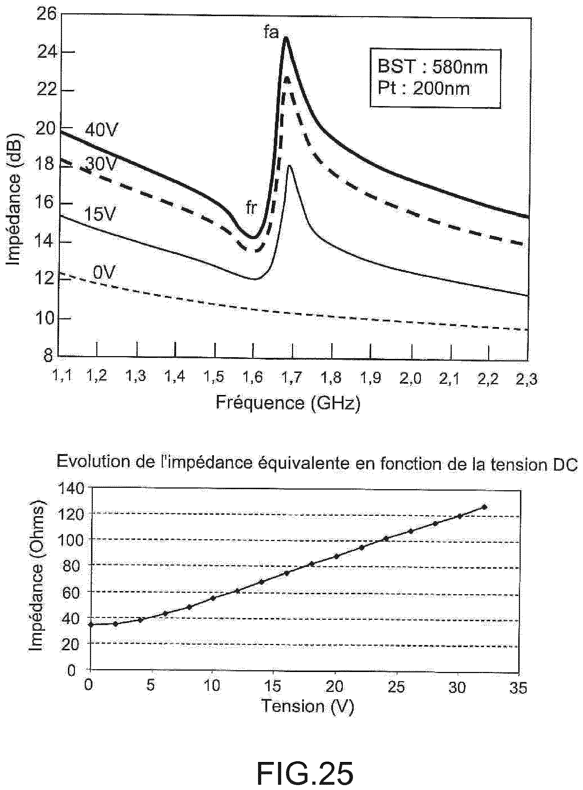

- la figure 25 illustre la variation d'impédance d'un résonateur à base de matériau pérovskite en fonction de la fréquence et de la tension appliquée, pouvant être utilisé dans un circuit résonant de l'invention ;

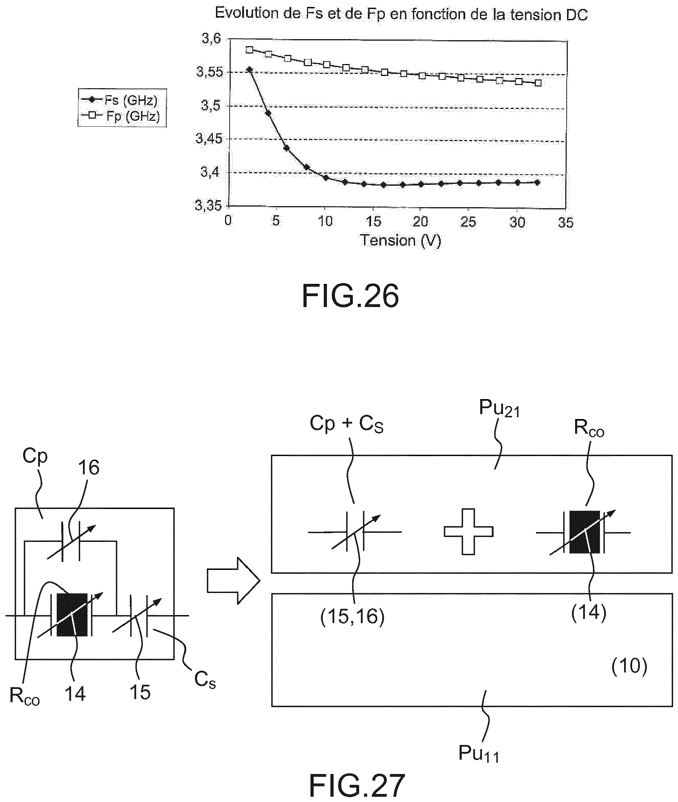

- la figure 26 illustre l'évolution des fréquences de résonance et d'antirésonance en fonction de la tension appliquée pour un résonateur à base de matériau pérovskite ;
- la figure 27 illustre un mode de réalisation comprenant un résonateur électrostrictif associé à des capacités ferroélectriques ;

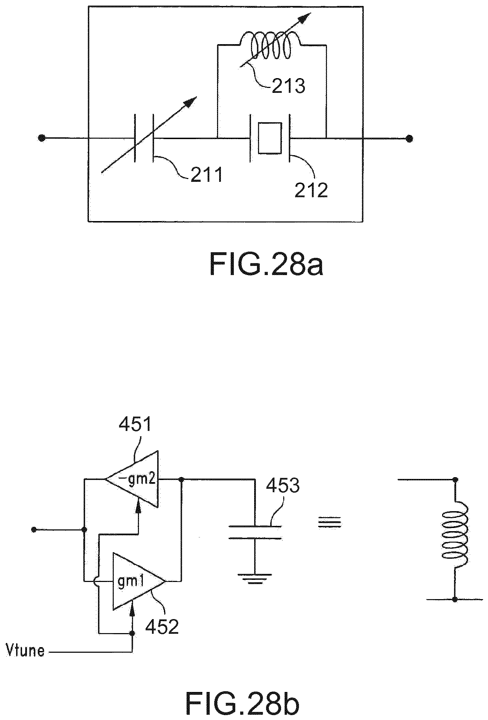

- les figures 28a et 28b illustrent des exemples de composants réactifs pouvant être utilisés dans un circuit résonant de l'invention.

De manière générale, le circuit résonant de la présente invention comprend les caractéristiques techniques selon la revendication 1.

Les premiers et seconds moyens de commande pour faire varier respectivement l'impédance caractéristique Zc dudit premier groupe, les impédances du premier et du second éléments d'adaptation d'impédance sont typiquement des moyens d'adressage sélectifs pouvant typiquement être des interrupteurs avec des commandes associées.

La figure 19 illustre une première variante de circuit résonant de l'invention, les éléments de réactance non nulle étant des capacités.

Cette figure met en évidence entre une borne ou un port d'entrée Pe et une borne ou un port de sortie Ps, le groupe schématisé par un résonateur $R_{C0}$ à capacité statique $C_0$ variable, associé au premier élément d'adaptation d'impédance de réactance non nulle représenté par une capacité variable en série Cs et associé au second élément d'adaptation d'impédance de réactance non nulle représenté par une capacité variable en parallèle Cp , les flèches indiquant une commande permettant de faire varier notamment les valeurs d'impédance.

Il est à noter que les capacités variables peuvent également être remplacées par des inductances variables en série et en parallèle, ou bien encore par une combinaison d'inductances et de capacités en série et en parallèle. Les propriétés de l'ensemble sont alors sensiblement différentes, et ouvrent potentiellement à de nouvelles applications de l'invention. L'invention suppose en effet l'association d'éléments réactifs variables de toute nature, avec un groupe de résonateurs constituant un résonateur à impédance caractéristique variable.

De manière générale, l'impédance Z d'un résonateur est caractérisée en première approche par l'impédance de son modèle équivalent de Butterworth-Van Dyke (BVD), précédemment présenté et illustré en figure 1, soit sans tenir compte d'éventuelles pertes :

$$Z = \frac{1}{j\omega\Phi} \quad \text{avec} \quad \Phi = \frac{L_m C_m C_0 \omega^2 - C_0 - C_m}{L_m C_m \omega^2 - 1} = \frac{N}{D}$$

Tous les éléments de ce modèle sont corrélés. Cela signifie que Lm, Cm et Co sont des variables interdépendantes, reliées aux caractéristiques technologiques du résonateur. La capacité Co est fixée par les dimensions géométriques du résonateur, et Lm et Cm sont calculés tels qu'ils rendent comptent des fréquences de résonance $\omega_r$ et d'antirésonance $\omega_a$ dudit résonateur, selon les équations suivantes :

$$\omega_r{}^2 = \frac{1}{L_m C_m} \qquad\qquad \omega_a{}^2 = \frac{C_0 + C_m}{L_m C_m C_0} = \omega_r{}^2 \left(1 + \frac{1}{\gamma}\right)$$

$$\gamma = \frac{C_0}{C_m}$$

avec

$$N = C_0 \cdot \left(D - \frac{1}{\gamma}\right)$$

Par ailleurs, l'impédance caractéristique $Z_c$ du résonateur en dehors des fréquences remarquables peut être définie lorsque $C_m \to 0$ (et donc en conséquence $\omega_r \to \infty$ et $\gamma \to \infty$). Ceci revient à éliminer l'effet piézoélectrique. On s'aperçoit alors que $Z_c$ correspond à l'impédance d'un condensateur de dimension Co.

$$Z_c = \frac{1}{j\omega C_0}$$

Lorsque l'on associe des composants en série et en parallèle avec ce résonateur, on obtient une nouvelle impédance $\overline{Z}$, caractérisée par de nouvelles fréquences de résonance et d'antirésonance, et une nouvelle impédance caractéristique $\overline{Z_c}$.

Plus précisément dans le cas d'un résonateur associé à une capacité en série Cs et à une capacité en parallèle Cp, selon le schéma illustré en figure 19, on peut alors démontrer que l'impédance $\overline{Z}$ présente les nouvelles fréquences de résonance et d'antirésonance, déterminées respectivement par l'annulation du dénominateur ou du numérateur de $\overline{\Phi}$ défini comme suit :

$$\overline{Z} = \frac{1}{j\omega\overline{\Phi}} \quad \text{avec} \quad \overline{\Phi} = \frac{(N + C_p D) \cdot C_s}{N + (C_p + C_s) \cdot D}$$

Et

$$\overline{\omega_r} = \omega_r \sqrt{1 + \frac{1}{\gamma} \cdot \frac{C_0}{C_0 + C_p + C_s}} \qquad\qquad \overline{\omega_a} = \omega_r \sqrt{1 + \frac{1}{\gamma} \cdot \frac{C_0}{C_0 + C_p}}$$

La nouvelle impédance caractéristique $\overline{Z_c}$ est définie comme celle d'un condensateur de dimension :

$$\overline{C_0} = \frac{(C_0 + C_p) \cdot C_s}{C_0 + C_p + C_s}$$

Donc

$$\overline{Z_c} = \frac{1}{j\omega\overline{C_0}}$$

La figure 20 met en évidence la réponse fréquentielle de l'impédance Z et de celle $\overline{Z}$ ainsi que celle de $\overline{C_0}$.

Il est particulièrement intéressant de noter la constance du paramètre $\overline{C_0}$ en fonction de la fréquence.

Ainsi, trois équations indépendantes existent donc pour définir trois paramètres ($\overline{Z_c}$, $\overline{\omega_r}$ et $\overline{\omega_a}$) en fonction de la nature intrinsèque du résonateur ($Z_c$, $\omega_r$ et $\omega_a$) et des deux capacités associées. En d'autres termes, il existe toujours une solution et une seule pour établir les valeurs $\overline{Z_c}$, $\overline{\omega_r}$ et $\overline{\omega_a}$ à partir de Co, Cp et Cs. En jouant donc sur la dimension géométrique du résonateur, et sur les valeurs de Cs et Cp, on peut positionner librement un pôle et un zéro, associés à une impédance caractéristique choisie.

Cette caractéristique est une caractéristique fondamentale de la présente invention.

Le champ des possibles pour des capacités Cp et Cs de valeur positive, est toutefois limité en fréquence par la borne inférieure que représente la résonance série du résonateur ($\omega_r$) et la borne supérieure que représente son antirésonance ($\omega_a$), elle-même déterminée par le coefficient de couplage intrinsèque (caractérisé par le paramètre $\gamma$ dans le modèle équivalent), que l'on voit d'ailleurs apparaitre comme des constantes dans les équations de $\overline{\omega_r}$ et $\overline{\omega_a}$.

Ces limites se retrouvent lorsque $C_s \to \infty$ et $C_p \to 0$.

La figure 21 illustre une seconde variante de l'invention dans laquelle la capacité Cp, montée en parallèle, est montée différemment de celle de la précédente variante. Elle est placée en parallèle avec l'ensemble constitué du résonateur et de l'élément série Cs. Dans ce cas, $\overline{\Phi}$ est défini comme suit :

$$\overline{\Phi} = \frac{\Phi \cdot \left(C_s + C_p\right) + C_s \cdot C_p}{\Phi + C_s}$$

$$\overline{\omega_r} = \omega_r \sqrt{1 + \frac{1}{\gamma} \cdot \frac{C_0}{C_0 + C_s}} \qquad \overline{\omega_a} = \omega_r \sqrt{1 + \frac{1}{\gamma} \cdot \frac{C_0}{C_0 + C_{sp}}}$$

Avec

$$C_{sp} = \frac{C_s \cdot C_p}{C_s + C_p}$$

Par ailleurs, l'impédance caractéristique $\overline{Z_c}$ est alors définie comme celle d'un condensateur de dimension ::

$$\overline{C_0} = \frac{C_s + C_p}{C_s + C_0} \cdot \left(C_0 + C_{sp}\right)$$

De manière générale, pour rendre l'impédance caractéristique d'un résonateur variable, il est nécessaire de faire varier sa capacité statique équivalente. Pour ce faire, une première technique consiste à faire varier les dimensions géométriques du résonateur. S'il existe des techniques dans le domaine des filtres à cavités microondes permettant de modifier les dimensions physiques des résonateurs par des moyens mécaniques (servomoteurs ou simplement vis de réglages), de tels moyens ne sont pas envisageables dans le cas de résonateurs intégrés.

C'est pourquoi, les Demandeurs proposent par exemple la solution décrite ci-après dans un premier exemple de réalisation.

Premier exemple de réalisation

Comme illustré en figure 22, un unique « grand » résonateur R$_{C0}$ à capacité statique C$_0$ variable peut être

équivalent à un groupe de résonateurs élémentaires Ri disposés en parallèle, les différents résonateurs présentant des fréquences de résonance et d'antirésonance identiques, mais dont la capacité statique est telle que la somme des capacités statiques élémentaires est égale à la capacité statique $C_0$.

Ainsi, dans le cadre d'un résonateur BAW, de dimension 10Nx10N, il est possible de constituer un damier de 100 résonateurs BAW de dimensions NxN reliés ensemble électriquement en parallèle (la forme carrée suggérée par le mot « damier » n'est pas une limite en soi. En réalité, toute surface géométrique peut se trouver mise en parallèle avec une autre).

Selon la présente invention, il convient alors que le circuit résonant comprenne les caractéristiques techniques selon la revendication 1, parmi lesquelles :

- au moins ledit groupe ensemble de résonateurs élémentaires Ri ;
- de composants réactifs ;
- des moyens d'adressage sélectifs de commandes, pouvant typiquement être des interrupteurs avec des commandes associées.

Une telle configuration est illustrée en figure 23 et montre ce premier mode de réalisation comprenant des interrupteurs et des commandes associées, permettant de commuter des résonateurs élémentaires et des composants réactifs unitaires.

A ce jour, des résonateurs BAW à large plage de variation peuvent être conçus à partir de matériau LNO, selon un procédé de fabrication connu et décrit dans l'article de Pijolat, M. Deguet, C. Billard, C. Mercier, D., Reinhardt, A., « Bias controlled electrostrictive longitudinal resonance in X-cut lithium niobate thin films resonator », Applied Physics Letters , Volume: 98, Issue: 23.

Cependant, à l'heure actuelle, ce procédé n'est pas compatible avec une réalisation sur le même substrat que les interrupteurs et les commandes.

C'est pourquoi, il est proposé dans le présent exemple, pour réaliser un résonateur $R_{C0}$ en LNO comportant un ensemble de résonateurs élémentaires Ri, commandable depuis des premiers moyens de commande, associé à un premier élément d'adaptation série Cs et à un second élément d'adaptation parallèle Cp, pouvant être commandé via des moyens de commande, une configuration dans laquelle on combine :

- d'un côté une puce $Pu_{20}$ contenant au moins le résonateur $R_{C0}$ comprenant au moins deux résonateurs élémentaires Ri, en LNO ;
- et d'un autre côté, une puce $Pu_{10}$ contenant les interrupteurs et les composants réactifs Cp et Cs. Plus précisément, la puce $Pu_{10}$ comprend les moyens de commande 10 des résonateurs comportant un ensemble d'interrupteurs $I_{1i}$ et $I_{1j}$ de commande des résonateurs élémentaires, et les moyens de commande 11+12, comportant un ensemble d'interrupteurs $I_{2k}$ et $I_{2l}$.

Ces deux puces sont ensuite assemblées en vis-à-vis (flip-chip) via des interconnexions (par exemple avec des billes, des piliers en cuivre,...), au moyen de la technique de « copper pillar » qui consiste à former des contacts en cuivre en forme de piliers sur chacune des puces, à les aligner en vis-à-vis, puis à venir les souder ensemble par des techniques de collage métallique (compression mécanique et échauffement), pour diminuer au maximum l'empreinte et la résistance de ces interconnexions.

Selon cette approche, les interrupteurs peuvent être conçus à partir de transistors dont le dimensionnement suppose un compromis entre leur résistance parasite interne lors de l'état « fermé », et leur capacité parasite interne lors de l'état « ouvert ». Les capacités élémentaires, quant à elles, sont classiquement réalisées en plaçant une fine couche diélectrique en sandwich entre deux électrodes métalliques. La qualité du matériau diélectrique et des électrodes intervient dans le fonctionnement de l'ensemble.

De manière à réduire au mieux les pertes résistives et les capacités parasites de l'assemblage, et pour supporter d'éventuelles surtensions locales (typiquement 50 V pour des puissances en jeu de l'ordre de quelques Watts) on peut avantageusement réaliser ces interrupteurs et ces capacités sur un substrat de type SOI Haute Résistivité.

La figure 24 illustre plus en détails un exemple d'interconnexions des deux puces dans le cadre d'une première puce en LNO et d'une seconde puce HR-SOI (technologie de fabrication de circuits intégrés utilisant une couche mince de silicium Haute Résistivité (HR) disposée sur une couche d'isolant électrique, elle-même recouvrant un substrat massif de silicium).

La puce $Pu_{10}$ comprend :

- un substrat 100 pouvant être en silicium ;
- un isolant électrique 101 ;
- un circuit électrique 102 comportant les capacités, les interrupteurs et de circuits de commande ;

- une couche de passivation 103.

La puce $Pu_{20}$ comprend :

- un substrat 200 en silicium ;
- un isolant acoustique 201 ;
- un isolant électrique 202
- une électrode inférieure 203 ;
- une couche de matériau LNO 204 ;
- une électrode supérieure 205.

Les puces $Pu_{10}$ et $Pu_{20}$ sont interconnectées via des piliers $I_{Pu10-Pu20}$ comportant une partie de métallisation intermédiaire 300 et une partie de métallisation de contact 301.

Second exemple de réalisation

Selon un second mode de réalisation, le circuit résonant comprend des résonateurs acoustiques à ondes de surface. Ces résonateurs sont avantageusement réalisés sur des substrats fortement piézoélectriques tels que le Niobate de Lithium présentant une orientation cristalline permettant l'excitation d'ondes de surface fortement couplées, par exemple de type « pseudo-ondes de surface ». Dans le cas des résonateurs SAW, l'impédance caractéristique ne dépend plus de la surface d'un condensateur plan, mais d'une capacité produite par l'agencement d'électrodes inter-digitées. Un résonateur SAW à 10 N électrodes peut être obtenu par la mise en parallèle de 10 résonateurs SAW à N électrodes chacun. La mise en oeuvre au niveau des commandes et des interconnexions peut être équivalente à celle décrite dans le cadre du premier exemple de réalisation.

Troisième exemple de réalisation

Selon un troisième mode de réalisation, les résonateurs du circuit résonant selon la revendication 1 sont des résonateurs électrostrictifs, c'est-à-dire aux propriétés piézoélectriques activables sous l'effet d'une tension. C'est le cas par exemple du matériau BST, un matériau d'organisation cristallographique dite pérovskite. Ce matériau a été employé dans le cadre de la demande de brevet EP2405574.

Dans un cas qui ne fait pas partie de l'invention, il est possible d'utiliser un unique résonateur, l'application d'une tension continue aux bornes dudit résonateur entraine une variation de la capacité statique du résonateur comme illustré par exemple sur la figure 25 relative aux figures extraites de la demande de brevet EP 2405574 et qui montrent la variation d'impédance d'un résonateur à base de matériau pérovskite respectivement en fonction de la fréquence et de la tension appliquée. Dans cette demande de brevet, il est enseigné que les résonateurs sont employés dans une zone de fonctionnement où les fréquences de résonance et d'antirésonance sont relativement constantes. Il y est proposé de produire un filtre à fréquence centrale et à largeur de bande fixe, mais dont l'impédance caractéristique varie. Un tel filtre trouve sa place dans les systèmes d'adaptation dynamique, par exemple décrits dans les brevets d'Emeric De Foucauld et al. (EP2509227 ou EP2509222).

Il est à noter également que dans la demande de brevet EP 2405574, il n'est pas question de faire varier les fréquences du filtre. Au contraire, les résonateurs fonctionnent dans une zone où le filtre ainsi constitué reste stable en fréquence.

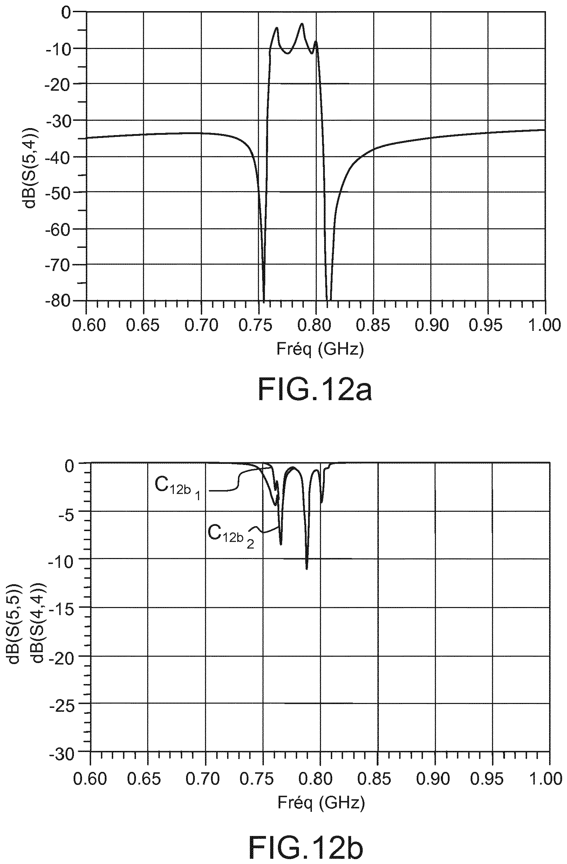

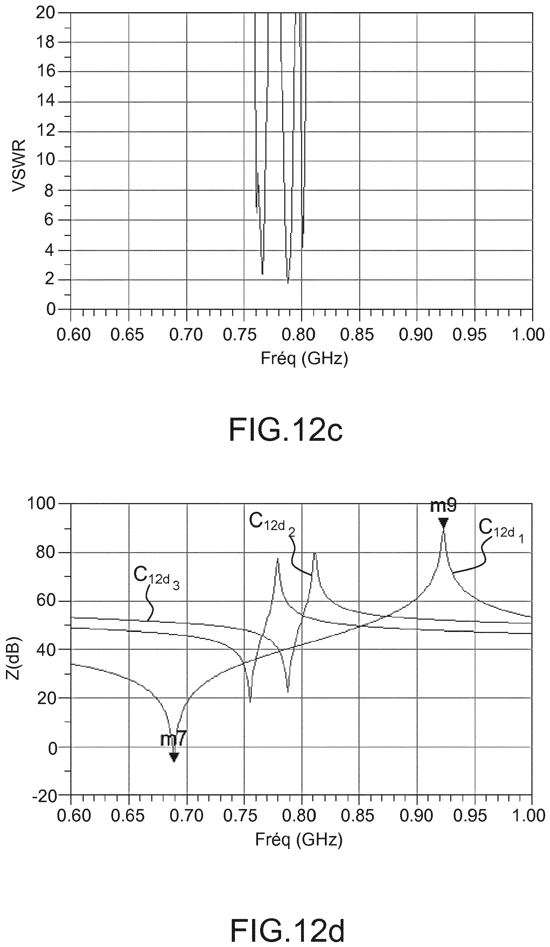

Dans la zone où il existe une variation en fréquence, on constate une grande disparité dans le positionnement relatif des fréquences de résonance et d'antirésonance, comme indiqué sur la figure 26 qui reprend la figure 12 de la demande de brevet EP 2405574.

Ainsi, la fréquence d'antirésonance (Fp) diminue faiblement (1.5%) lorsque la tension appliquée augmente (jusqu'à 10 V), tandis que la fréquence de résonance (Fs) diminue de 5% sur la même plage de tension. Dans cette zone de travail, l'impédance caractéristique reste à 50 $\Omega$ +/-10 $\Omega$. Ce type de variation n'autorise pas la réalisation de la solution de la présente invention, car les deux fréquences remarquables ainsi que l'impédance caractéristique évoluent de manière interdépendante.

Cependant, à partir de l'approche développée dans cette demande de brevet EP2405574, et en cherchant à contrôler les fréquences de résonance et d'antirésonance selon la présente invention, on peut associer ces résonateurs électrostrictifs (dans leur zone de fonctionnement où les fréquences remarquables sont à peu près stables) à des capacités variables en série et en parallèle. Cette approche permet de désigner à nouveau un ensemble (Co, Cs, Cp) qui permet de déterminer indépendamment l'impédance caractéristique, la fréquence de résonance, et la fréquence d'antirésonance.

Il est à noter que l'usage du BST pour réaliser les résonateurs, permet de co-intégrer des capacités variables au sein de la même puce selon la technique décrite dans le brevet d'invention EP2713508. En effet, en empêchant les mouvements élastiques de la couche (par exemple à l'aide d'une surcharge mécanique), on peut transformer un résonateur acoustique en simple capacité variable.

Une telle puce est alors connectée à un circuit actif responsable de fournir une tension de polarisation pour chaque résonateur et capacité, de manière à ajuster dynamiquement les valeurs des capacités statiques des résonateurs, et des capacités ajoutées aux résonateurs.

La figure 27 schématise ce troisième exemple de circuit selon l'invention, dans lequel deux puces sont interconnectées. Une puce intègre les fonctions des résonateurs $R_{C0}$ et les capacités Cp et Cs, une autre puce intègre les moyens de commandes des capacités ferroélectriques et celles des résonateurs électrostrictifs. Plus précisément la première puce $Pu_{11}$ comprend les moyens de commande 14 des résonateurs électrostrictifs et les moyens de commande 15, 16 des capacités ferroélectriques. La seconde puce $Pu_{21}$ comprend les résonateurs électrostrictifs $R_{C0}$ et les capacités ferroélectriques Cp et Cs.

Quatrième exemple de réalisation

Selon un quatrième mode de réalisation, les composants réactifs sont réalisés avec des circuits actifs.

En effet, on sait réaliser ces réactances à l'aide de circuits électroniques à base de transistors, plutôt que d'employer des éléments passifs. Les condensateurs variables sont régulièrement réalisés avec des diodes montées en inverse dont la capacité dépend de la tension continue appliquée à ses bornes. Les composants réactifs utilisés peuvent aussi être ceux décrits par exemple dans le brevet US 7.187.240, portant sur l'association d'un résonateur BAW avec des composants réactifs, ces derniers sont réalisés comme indiqués sur les figures extraites du brevet US 7 187 240 et illustrées en figure 28a et 28b.

## Revendications

1. Circuit résonant, à impédance caractéristique stabilisée comprenant une borne d'entrée (Pe) et une borne de sortie (Ps) et au moins :

   - un groupe de N résonateurs piézoélectriques avec N >1, lesdits résonateurs ayant la même fréquence de résonance et la même fréquence d'antirésonance, lesdits résonateurs étant disposés en parallèle de manière que la somme de leurs capacités statiques élémentaires est égale à une capacité statique dudit groupe ;
   - un premier élément d'adaptation d'impédance (Cs) présentant une réactance n non nulle et un second élément d'adaptation d'impédance (Cp) présentant une réactance non nulle, le premier élément d'adaptation d'impédance étant en série avec ledit groupe de N résonateurs, et le second élément d'adaptation d'impédance étant en parallèle avec ledit groupe de N résonateurs,

   ledit circuit résonant comprenant :

   - des premiers moyens de commande dudit groupe de résonateurs agencés pour permettre de fixer la capacité statique ($C_0$) dudit groupe à une première valeur ;
   - des seconds moyens de commande agencés pour permettre de fixer l'impédance du premier élément d'adaptation d'impédance et celle du second élément d'adaptation d'impédance égales à des secondes valeurs ; lesdites première et secondes valeurs étant telles que :
   - le triplet de valeurs : capacité statique dudit groupe / impédance du premier élément d'adaptation d'impédance/ impédance du second élément d'adaptation d'impédance ($C_0$, Cs, Cp) détermine, pour l'impédance $\overline{Z}$ de l'ensemble constitué par ledit groupe, ledit premier élément d'adaptation d'impédance et ledit second élément d'adaptation, un triplet de paramètres suivants

       ◦ une impédance caractéristique $\overline{Z_c}$ dudit ensemble ;
       ◦ la fréquence de résonance $\overline{\omega_r}$ dudit ensemble ;
       ◦ la fréquence d'antirésonance $\overline{\omega_a}$ dudit ensemble ;,

   pour stabiliser l'impédance caractéristique dudit circuit à une impédance caractéristique choisie.

2. Circuit résonant selon la revendication 1, **caractérisé en ce que** :

- ledit groupe de N résonateurs est constitué de plusieurs résonateurs (Ri) :
- lesdits premiers moyens de commande comprenant un circuit de commutation permettant de sélectionner et de relier un ou plusieurs résonateurs.

3. Circuit résonant selon la revendication 2, **caractérisé en ce que** les résonateurs sont des résonateurs à ondes de volume (BAW) pouvant présenter des dimensions géométriques différentes.

4. Circuit résonant selon la revendication 2, **caractérisé en ce que** les résonateurs sont des résonateurs à ondes de surface (SAW), pouvant comporter des agencements d'électrodes différents à la surface d'un substrat piézoélectrique.

5. Circuit résonant selon l'une des revendications 1 à 4, **caractérisé en ce qu'**au moins un élément d'adaptation d'impédance est un condensateur, une inductance ou un ensemble d'éléments passifs.

6. Circuit résonant selon l'une des revendications 1 à 5, **caractérisé en ce qu'**au moins un élément d'adaptation d'impédance est un circuit actif.

7. Circuit résonant selon la revendication 6, **caractérisé en ce que** le circuit actif comprend des transistors.

8. Circuit résonant selon l'une des revendications 1 à 7, **caractérisé en ce que** le second élément d'adaptation d'impédance est relié d'une part à une des bornes d'entrée/sortie et d'autre part à un noeud intermédiaire entre le groupe de résonateurs et ledit premier élément d'adaptation d'impédance.

9. Circuit résonant selon l'une des revendications 1 à 8, **caractérisé en ce que** le second élément d'adaptation d'impédance est placé entre les bornes d'entrée et de sortie, monté en parallèle de l'ensemble : groupe de résonateurs/ premier élément d'adaptation d'impédance placés en série..

10. Circuit résonant selon l'une des revendications 1 à 9, **caractérisé en ce qu'**il comprend :

   - une première puce comprenant au moins lesdits premiers moyens de commande pour fixer la capacité statique ($C_0$) dudit groupe de résonateurs à une première valeur ;
   - une seconde puce comprenant ledit groupe de résonateurs ;
   - des moyens d'interconnexion desdits premiers moyens de commande avec ledit groupe de résonateurs .

11. Circuit résonant selon la revendication 10, **caractérisé en ce que** la première puce ($Pu_{10}$) comporte en outre les premier et second éléments d'adaptation d'impédance (Cs,Cp).

12. Circuit résonant selon la revendication 10, **caractérisé en ce que** la seconde puce ($Pu_{21}$) comporte en outre les premier et second éléments d'adaptation d'impédance (Cs,Cp).

13. Filtre comprenant un ensemble de circuits résonants selon l'une des revendications 1 à 12.

14. Duplexeur comprenant un ensemble de circuits résonants selon l'une des revendications 1 à 12.

15. Dispositif comprenant un ensemble d'au moins deux circuits résonants selon l'une des revendications 1 à 12 et présentant une impédance d'entrée et une impédance de sortie, compris entre un port d'entrée et un port de sortie, **caractérisé en ce qu'**il comprend :

   - des premiers moyens de commande de groupe de résonateurs et des seconds moyens de commande des premiers et seconds éléments d'adaptation d'impédance, pour régler :

      ◦ l'impédance caractéristique de chacun desdits circuits ;
      ◦ les fréquences de résonance et d'antirésonance de chacun desdits circuits.

16. Dispositif comprenant un ensemble d'au moins deux circuits résonants selon l'une des revendications 1 à 12, dans lequel lesdits premiers moyens de commande de groupe de résonateurs de chacun desdits circuits et lesdits seconds moyens de commande des premiers et seconds éléments d'adaptation d'impédance de chacun desdits circuits sont agencés pour permettre de fixer les triplets de valeurs pour chacun desdits circuits :

capacité statique dudit groupe / impédance du premier élément d'adaptation d'impédance/ impédance du second élément d'adaptation d'impédance pour:

◦ régler les valeurs d'impédances caractéristiques des deux circuits résonants à des valeurs fixées ;
◦ faire varier les fréquences de résonance et d'antirésonance des deux circuits résonants.

17. Dispositif comprenant un ensemble d'au moins deux circuits résonants selon l'une des revendications 1 à 12, dans lequel lesdits premiers moyens de commande de groupe de résonateurs et lesdits seconds moyens de commande des premiers et seconds éléments d'impédance sont agencés pour permettre de fixer les triplets de valeurs pour chacun desdits circuits : capacité statique dudit groupe de résonateurs / impédance du premier élément d'adaptation d'impédance/ impédance du second élément d'adaptation d'impédance pour :

◦ faire varier les valeurs d'impédances caractéristiques des deux circuits résonants ;
◦ régler les fréquences de résonance et d'antirésonance des deux circuits résonants à des valeurs fixées.

**Patentansprüche**

1. Resonanzschaltung mit stabilisierter charakteristischer Impedanz, die einen Eingangsanschluss (Pe) und einen Ausgangsanschluss (Ps) und wenigstens Folgendes umfasst:

- eine Gruppe von N piezoelektrischen Resonatoren, wobei N > 1 ist, wobei die Resonatoren dieselbe Resonanzfrequenz und dieselbe Antiresonanzfrequenz haben, wobei die Resonatoren parallel auf eine solche Weise geschaltet sind, dass die Summe ihrer elementaren statischen Kapazitäten gleich einer statischen Kapazität der Gruppe ist;
- ein erstes Impedanzadaptionselement (Cs), das eine Reaktanz n von ungleich null aufweist, und ein zweites Impedanzadaptionselement (Cp), das eine Reaktanz von ungleich null aufweist, wobei das erste Impedanzadaptionselement in Serie mit der Gruppe von N Resonatoren geschaltet ist und das zweite Impedanzadaptionselement parallel zu der Gruppe von N Resonatoren geschaltet ist, wobei die Resonanzschaltung Folgendes umfasst:
- erste Mittel zum Steuern der Resonatorgruppe, ausgelegt zum Zulassen des Festlegens der statischen Kapazität ($C_0$) der Gruppe auf einen ersten Wert;
- zweite Mittel zum Steuern, ausgelegt zum Zulassen des Festlegens der Impedanz des ersten Impedanzadaptionselements und der des zweiten Impedanzadaptionselements auf zweite Werte;

wobei der erste und der zweite Wert so sind, dass:

- das Wertetriplett: statische Kapazität der Gruppe/Impedanz des ersten Impedanzdaptionselements/Impedanz des zweiten Impedanzadaptionselements ($C_0$, Cs, Cp), für die Impedanz $\overline{Z}$ der durch die Gruppe, das erste Impedanzadaptionselement und das zweite Impedanzadaptionselement gebildeten Baugruppe ein Triplett der folgenden Parameter:

◦ eine charakteristische Impedanz $\overline{Z}_c$ der Baugruppe;
◦ die Resonanzfrequenz $\overline{\omega}_r$ der Baugruppe;
◦ die Antiresonanzfrequenz $\overline{\omega}_a$ der Baugruppe;

zum Stabilisieren der charakteristischen Impedanz der Schaltung auf einer gewählten charakteristischen Impedanz bestimmt.

2. Resonanzschaltung nach Anspruch 1, **dadurch gekennzeichnet, dass**:

- die Gruppe von N Resonatoren durch mehrere Resonatoren (Ri) gebildet wird;
- die ersten Steuermittel eine Umschaltschaltung umfassen, die das Wählen und Verbinden von einem oder mehreren Resonatoren zulässt.

3. Resonanzschaltung nach Anspruch 2, **dadurch gekennzeichnet, dass** die Resonatoren Volumenwellenresonatoren (BAW) sind, die unterschiedliche geometrische Abmessungen aufweisen können.

**4.** Resonanzschaltung nach Anspruch 2, **dadurch gekennzeichnet, dass** die Resonatoren Oberflächenwellenresonatoren (SAW) sind, die verschiedene Elektrodenanordnungen auf der Oberfläche eines piezoelektrischen Substrats haben können.

**5.** Resonanzschaltung nach einem der Ansprüche 1 bis 4, **dadurch gekennzeichnet, dass** wenigstens ein Impedanzadaptionselement ein Kondensator, eine Induktanz oder eine passive Elementebaugruppe ist.

**6.** Resonanzschaltung nach einem der Ansprüche 1 bis 5, **dadurch gekennzeichnet, dass** wenigstens ein Impedanzadaptionselement eine aktive Schaltung ist.

**7.** Resonanzschaltung nach Anspruch 6, **dadurch gekennzeichnet, dass** die aktive Schaltung Transistoren umfasst.

**8.** Resonanzschaltung nach einem der Ansprüche 1 bis 7, **dadurch gekennzeichnet, dass** das zweite Impedanzadaptionselement einerseits mit einem der Ein-/Ausgangsanschlüsse und andererseits mit einem Zwischenknoten zwischen der Resonanzgruppe und dem ersten Impedanzadaptionselement verbunden ist.

**9.** Resonanzschaltung nach einem der Ansprüche 1 bis 8, **dadurch gekennzeichnet, dass** das zweite Impedanzadaptionselement zwischen den Ein- und Ausgangsanschlüssen platziert ist, parallel zu der in Serie geschalteten Baugruppe: Resonatorgruppe/erstes Impedanzadaptionselement geschaltet.

**10.** Resonanzschaltung nach einem der Ansprüche 1 bis 9, **dadurch gekennzeichnet, dass** sie Folgendes umfasst:

- einen ersten Chip, der wenigstens die ersten Steuermittel zum Festlegen der statischen Kapazität ($C_0$) der Resonatorgruppe auf einem ersten Wert umfasst;
- einen zweiten Chip, der die Resonatorgruppe umfasst;
- Mittel zum Verbinden der ersten Steuermittel mit der Gruppe von Resonatoren.

**11.** Resonanzschaltung nach Anspruch 10, **dadurch gekennzeichnet, dass** der erste Chip ($Pu_{10}$) darüber hinaus die ersten und zweiten Impedanzadaptionselemente (Cs, Cp) umfasst.

**12.** Resonanzschaltung nach Anspruch 10, **dadurch gekennzeichnet, dass** der zweite Chip ($Pu_{21}$) darüber hinaus die ersten und zweiten Impedanzadaptionselemente (Cs, Cp) umfasst.

**13.** Filter, das einen Satz von Resonanzschaltungen nach einem der Ansprüche 1 bis 12 umfasst.

**14.** Duplexer, der einen Satz von Resonanzschaltungen nach einem der Ansprüche 1 bis 12 umfasst.

**15.** Vorrichtung, die eine Baugruppe aus wenigstens zwei Resonanzschaltungen nach einem der Ansprüche 1 bis 12 umfasst und eine Eingangsimpedanz und eine Ausgangsimpedanz aufweist, die zwischen einem Eingangsport und einem Ausgangsport vorliegt, **dadurch gekennzeichnet, dass** sie Folgendes umfasst:

- erste Mittel zum Steuern einer Resonatorgruppe und zweite Mittel zum Steuern von ersten und zweiten Impedanzadaptionselementen zum Regeln:

  ◦ der charakteristischen Impedanz von jeder der Schaltungen;
  ◦ der Resonanz- und Antiresonanzfrequenz von jeder der Schaltungen.

**16.** Vorrichtung, die eine Baugruppe von wenigstens zwei Resonanzschaltungen nach einem der Ansprüche 1 bis 12 umfasst, wobei die ersten Mittel zum Steuern der Gruppe von Resonatoren von jeder der Schaltungen und die zweite Mittel zum Steuern der ersten und zweiten Impedanzadaptionselemente von jeder der Schaltungen so ausgelegt sind, dass sie das Festlegen des Wertetripletts für jede der Schaltungen: statische Kapazität der Gruppe/Impedanz des ersten Impedanzadaptionselements/Impedanz des zweiten Impedanzadaptionselements zulassen, zum:

  ◦ Regeln der charakteristischen Impedanzwerte der beiden Resonanzschaltungen auf feste Werte;
  ◦ Variieren der Resonanz- und Antiresonanzfrequenzen der beiden Resonanzschaltungen.

**17.** Vorrichtung, die eine Baugruppe von wenigstens zwei Resonanzschaltungen nach einem der Ansprüche 1 bis 12 umfasst, wobei die ersten Mittel zum Steuern der Gruppe von Resonatoren und die zweiten Mittel zum Steuern der ersten und zweiten Impedanzelemente so ausgelegt sind, dass sie das Festlegen des Wertetripletts für jede der Schaltungen: statische Kapazität der Resonatorgruppe/Impedanz des ersten Impedanzadaptionselements/Impedanz des zweiten Impedanzadaptionselements zulassen, zum:

- ○ Variieren der charakteristischen Impedanzwerte der beiden Resonanzschaltungen;
- ○ Regeln der Resonanz- und Antiresonanzfrequenzen der beiden Resonanzschaltungen auf feste Werte.

## Claims

1. Resonant circuit with characteristic stabilized impedance, comprising an input terminal (Pe) and an output terminal (Ps), and at least:

   - a group of N piezoelectric resonators, where N > 1, said resonators having the same resonance frequency and the same antiresonance frequency, said resonators being arranged in parallel such that the sum of their elementary static capacitances is equal to a static capacitance of said group;
   - a first impedance matching element (Cs) having a non-zero reactance and a second impedance matching element (Cp) having a non-zero reactance, the first impedance matching element being in series with said group of N resonators, and the second impedance matching element being in parallel with said group of N resonators, said resonant circuit comprising:
   - first means for controlling said group of resonators, arranged to enable the static capacitance ($C_0$) of said group to be fixed at a first value;
   - second control means, arranged to enable the impedance of the first impedance matching element and that of the second impedance matching element to be fixed at second values;

   said first and second values being such that:

   the triplet of values: static capacitance of said group/impedance of the first impedance matching element/impedance of the second impedance matching element ($C_0$, Cs, Cp) determines for the impedance $\overline{Z}$ of the assembly formed by said group, said first impedance matching element and said second matching element, a following triplet of parameters:

   - ○ a characteristic impedance $\overline{Z_c}$ of said assembly;
   - ○ the resonance frequency $\overline{\omega_r}$ of said assembly;
   - ○ the antiresonance frequency $\overline{\omega_a}$ of said assembly;

   in order to stabilize the impedance of said circuit at a chosen characteristic impedance.

2. Resonant circuit according to claim 1, **characterized in that**:

   - said group of N resonators consists of a plurality of resonators (Ri):
   - said first control means comprising a switching circuit for selecting and connecting one or more resonators.

3. Resonant circuit according to claim 2, **characterized in that** the resonators are bulk acoustic wave (BAW) resonators which may have different geometrical dimensions.

4. Resonant circuit according to claim 2, **characterized in that** the resonators are surface acoustic wave (SAW) resonators which may have different arrangements of electrodes on the surface of a piezoelectric substrate.

5. Resonant circuit according to any of claims 1 to 4, **characterized in that** at least one impedance matching element is a capacitor, an inductance or a set of passive elements.

6. Resonant circuit according to any of claims 1 to 5, **characterized in that** at least one impedance matching element is an active circuit.

7. Resonant circuit according to claim 6, **characterized in that** the active circuit comprises transistors.

8. Resonant circuit according to any of claims 1 to 7, **characterized in that** the second impedance matching element is connected, on the one hand, to one of the input/output terminals, and on the other hand to an intermediate node between the group of resonators and said first impedance matching element.

9. Resonant circuit according to any of claims 1 to 8, **characterized in that** the second impedance matching element is placed between the input and output terminals, fitted in parallel with the assembly: group of resonators/first impedance matching element, placed in series.

10. Resonant circuit according to any of claims 1 to 9, **characterized in that** it comprises:

   - a first chip comprising at least said first control means for fixing the static capacitance ($C_0$) of said group of resonators at a first value;
   - a second chip comprising said group of resonators;
   - means for the interconnection of said first control means with said group of resonators.

11. Resonant circuit according to claim 10, **characterized in that** the first chip ($Pu_{10}$) also comprises the first and second impedance matching elements (Cs, Cp).

12. Resonant circuit according to claim 10, **characterized in that** the second chip ($Pu_{21}$) also comprises the first and second impedance matching elements (Cs, Cp).

13. Filter comprising a set of resonant circuits according to any of claims 1 to 12.

14. Duplexer comprising a set of resonant circuits according to any of claims 1 to 12.

15. Device comprising a set of at least two resonant circuits according to any of claims 1 to 12 and having an input impedance and an output impedance, contained between an input port and an output port, **characterized in that** it comprises:

   - first means for controlling the group of resonators and second means for controlling the first and second impedance matching elements, for adjusting:

      ∘ the characteristic impedance of each of said circuits;
      ∘ the resonance and antiresonance frequencies of each of said circuits.

16. Device comprising a set of at least two resonant circuits according to any of claims 1 to 12, said first means for controlling the group of resonators of each of said circuits and said second means for controlling the first and second impedance matching elements of each of said circuits being arranged to enable the triplets of values for each of said circuits: static capacitance of said group/impedance of the first impedance matching element/impedance of the second impedance matching element to be fixed for the purpose of:

      ∘ adjusting the values of characteristic impedance of the two resonant circuits to fixed values;
      ∘ causing the resonance and antiresonance frequencies of the two resonant circuits to vary.

17. Device comprising a set of at least two resonant circuits according to any of claims 1 to 12, said first means for controlling the group of resonators and said second means for controlling the first and second impedance matching elements being arranged to enable the triplets of values for each of said circuits: static capacitance of said group/impedance of the first impedance matching element/impedance of the second impedance matching element to be fixed for the purpose of:

      ∘ causing the values of characteristic impedance of the two resonant circuits to vary;
      ∘ adjusting the resonance and antiresonance frequencies of the two resonant circuits to fixed values.

FIG.1a

FIG.1b

FIG.1c

FIG.2

FIG.3

FIG.4

FIG.5a

FIG.5b

FIG.6a

FIG.6b

FIG.7a

FIG.7b

FIG.8

FIG.9

FIG.10a

FIG.10b

FIG.10c

FIG.10d

FIG.11a

FIG.11b

FIG.11c

FIG.11d

FIG.12a

FIG.12b

FIG.12c

FIG.12d

EP 3 010 149 B1

FIG.13a

FIG.13b

34

FIG.13c

FIG.13d

FIG.14a

FIG.14b

FIG.14c

FIG.14d

FIG.15a

FIG.15b

FIG.15c

FIG.15d

FIG.16a

FIG.16b

FIG.16c

Maintien de l'impédance
des circuits résonnants

FIG.16d

FIG.17

EP 3 010 149 B1

FIG.18

FIG.19

FIG.20

FIG.21

FIG.22

FIG.23

FIG.24

FIG.25

Evolution de Fs et de Fp en fonction de la tension DC

FIG.26

FIG.27

FIG.28a

FIG.28b

## RÉFÉRENCES CITÉES DANS LA DESCRIPTION

**Documents brevets cités dans la description**

- US 2007296513 A
- US 2012313731 A
- EP 2405574 A
- EP 2509227 A, Emeric De Foucauld

- EP 2509222 A
- EP 2713508 A
- US 7187240 B

**Littérature non-brevet citée dans la description**

- **CARPENTIER, J.F. ; TILHAC, C. ; CARUYER, G. ; DUMONT, F.** A tunable bandpass BAW-filter architecture and its application to WCDMA filte. *IEEE MTT-S International Microwave Symposium Digest,* 2005
- **RAZAFIMANDIMBY, S ; TILHAC, C. ; CATHELIN, A. ; KAISER, A.** An Electronically Tunable Bandpass BAW-Filter for a Zero-IF WCDMA Receiver. *Proceedings of the 32nd European Solid-State Circuits Conference,* 2006
- **CYRILLE TILHAC ; ANDREIA CATHELIN ; ANDREAS KAISER ; DIDIER BELOT.** Digital tuning of an analog tunable bandpass BAW-filter at GHz frequency. *33rd European Solid State Circuits Conference,* 2007
- **S. GEVORGIAN ; A. VOROBIEV ; T. LEWIN.** DC field and temperature dépendent acoustic résonances in parallel-plate capacitors based on SrTiO3 and Ba0.25Sr0.75TiO3 films: experiment and modeling. *Journal of Applied Physics,* 2006, vol. 99, 124112
- **R. AIGNER.** Tunable acoustic RF-filters: discussion of requirements and potential physical embodiments. *Proceedings of the 40th European Microwave Conference,* 2010, 787
- **TOMOYA KOMATSU ; KEN-YA HASHIMOTO ; TATSUYA OMORI ; MASATSUNE YAMAGUCHI.** Tunable Radio-Frequency Filters Using Acoustic Wave Resonators and Variable Capacitors. *Japanese Journal of Applied Physics,* 2010, vol. 49

- **T. YASUE ; T. KOMATSU ; N. NAKAMURA ; K. K. HASHIMOTO.** Wideband tunable love wave filter using electrostatically-actuated MEMS variable capacitors integrated on lithium niobate. *16th International Solid-State Sensors, Actuators and Microsystems Conférence (TRANSDUCERS),* 2011
- **KEN-YA HASHIMOTO ; S. TANAKA ; M. ESASHI.** Tunable RF SAW/BAW filters: Dream or reality. *Joint Conférence of the IEEE International Frequency Control and the European Frequency and Time Forum (IFCS),* 2011
- **M. INABA ; K.-Y. HASHIMOTO ; T. OMORI ; C. AHN.** A widely tunable filter configuration composed of high Q RF resonators and variable capacitors. *European Microwave Integrated Circuits Conférence (EuMIC),* 2013
- **HIDEKI HIRANO ; TETSUYA KIMURA ; IVOYL P KOUTSAROFF ; MICHIO KADOTA ; KEN-YA HASHIMOTO ; MASAYOSHI ESASHI ; SHUJI TANAKA.** Intégration of BST varactors with surface acoustic wave device by film transfer technology for tunable RF filters. *Journal of Micromechanics and Microengineering,* 2013
- **A. REINHARDT ; E. DEFAÿ ; F. PERRUCHOT ; C. BILLARD.** Tunable composite piezoelectric resonators: a possible 'Holy Grail' of RF filters. *Proceedings of the International Microwave Symposium,* 2012
- **PIJOLAT, M. ; DEGUET, C. ; BILLARD, C. ; MERCIER, D. ; REINHARDT, A.** Bias controlled electrostrictive longitudinal resonance in X-cut lithium niobate thin films resonator. *Applied Physics Letters,* vol. 98